(19) Europäisches Patentamt
European Patent Office
Office européen des brevets

(11) **EP 4 593 565 A1**

(12) **EUROPEAN PATENT APPLICATION**

(43) Date of publication:
**30.07.2025 Bulletin 2025/31**

(21) Application number: **24223828.5**

(22) Date of filing: **31.12.2024**

(51) International Patent Classification (IPC):
**H10K 50/15** (2023.01)    **H10K 50/19** (2023.01)
**H10K 50/852** (2023.01)    **H10K 59/80** (2023.01)

(52) Cooperative Patent Classification (CPC):
**H10K 50/19; H10K 50/156; H10K 50/852;
H10K 59/876**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.01.2024 KR 20240011781**

(71) Applicant: **LG Display Co., Ltd.**
**Seoul, 07336 (KR)**

(72) Inventors:
• **MOON, Sang Kyoung**
**10845 Paju-si (KR)**

• **JIN, Bo A**
**10845 Paju-si (KR)**
• **ROH, Seung Kwang**
**10845 Paju-si (KR)**
• **CHOI, Woo Chul**
**10845 Paju-si (KR)**
• **LEE, Chi Hak**
**10845 Paju-si (KR)**
• **SHIN, Min Gue**
**10845 Paju-si (KR)**

(74) Representative: **Ter Meer Steinmeister & Partner
Patentanwälte mbB
Nymphenburger Straße 4
80335 München (DE)**

(54) **LIGHT EMITTING DEVICE AND LIGHT EMITTING DISPLAY DEVICE INCLUDING THE SAME**

(57) A light emitting device can include a first electrode and a second electrode configured to face each other, and first to $m^{th}$ (m being a natural number of 3 or more) light emitting stacks provided between the first electrode and the second electrode. Each light emitting stack includes a light emitting layer configured to emit light of the same color. The light emitting device can further include first to $(m-1)^{th}$ charge generation layers provided between adjacent light emitting stacks among the first to $m^{th}$ light emitting stacks. Each of the light emitting layers provided in the first to $m^{th}$ light emitting stacks can be located in a resonance distance of an $(m-1)^{th}$ or less order.

FIG. 4

EP 4 593 565 A1

## Description

This application claims priority to Korean Patent Application No. 10-2024-0011781, filed in the Republic of Korea on January 25, 2024.

## BACKGROUND OF THE DISCLOSURE

### Field

The present disclosure relates to a light emitting device, and more particularly, to a light emitting device and a light emitting display device including the same that can be driven with low power while maintaining high luminous efficacy.

### Discussion of the Related Art

As society enters the information age, the field of display devices that visually display electrical information signals has been developed rapidly, and in response to this, various display devices having excellent performance, such as thinness, lightness, and low power consumption, is being developed.

Among these devices, a light emitting display device, which does not require any separate light source and has light emitting devices within a display panel for compactness of the device and clear color display, is being considered as a competitive application.

The light emitting device can include an anode and a cathode opposite each other as electrodes, a light emitting layer interposed between the anode and the cathode, and common layers which transport holes and electrons to the light emitting layer.

The light emitting device uses a plurality of organic layers to increase efficiency, but there can be a problem in that power consumption can increase due to the increased thickness of the organic layers.

## SUMMARY OF THE DISCLOSURE

Accordingly, an object of the present disclosure is directed to a light emitting device and a light emitting display device including the same that substantially obviate one or more problems due to limitations and disadvantages of the related art.

An object of the present disclosure is to provide a light emitting device and a light emitting display device including the same that has high efficiency and that can achieve low power consumption, improve pure color characteristics, and maintain high efficiency.

According to the present disclosure a light emitting device and a light emitting display device including the same is provided that include a plurality of stacks to have high efficiency in a structure of subpixels, which emit light of different colors, and can thus reduce a thickness between opposing electrodes to achieve low power consumption, improve pure color characteristics, and maintain high efficiency.

At least one of these objects is solved by the features of the independent claim. Additional advantages, objects, and features of the disclosure will be set forth in part in the description which follows and in part will become apparent to those having ordinary skill in the art upon examination of the following or can be learned from practice of the disclosure. The objectives and other advantages of the disclosure can be realized and attained by the structure particularly pointed out in the written description and claims hereof as well as the appended drawings.

According to one aspect, a light emitting device includes a first electrode and a second electrode facing each other, first to $m^{th}$ light emitting stacks between the first electrode and the second electrode, each light emitting stack comprising a light emitting layer to emit light of the same color, and first to $(m-1)^{th}$ charge generation layers between adjacent light emitting stacks among the first to $m^{th}$ light emitting stacks, wherein each light emitting layer in the first to $m^{th}$ light emitting stacks is located in a resonance distance of an $(m-1)^{th}$ or less order. Here, m may be a natural number of 3 or more.

A light emitting display device according to a further aspect of the present disclosure comprises a substrate comprising a first subpixel, a second subpixel, and a third subpixel; a red light emitting device disposed at the first subpixel; a green light emitting device disposed at the second subpixel; and a blue light emitting device disposed at the third subpixel. Each of the red light emitting device, the green light emitting device, and the blue light emitting device comprises a first electrode and a second electrode to face each other. At least one of the red light emitting device, the green light emitting device, and the blue light emitting device comprises: first to $m^{th}$ light emitting stacks between the first electrode and the second electrode, where m is a natural number of 3 or more, each light emitting stack comprising a light emitting layer to emit light of a same color; and first to $(m-1)^{th}$ charge generation layers provided between adjacent light emitting stacks among the first to $m^{th}$ light emitting stacks. Light emitting layers in the first to $m^{th}$ light emitting stacks are located in a resonance distance of an $(m-1)^{th}$ or less order.

A light emitting device and a light emitting display device including the same according to one or more aspects of the present disclosure include a plurality of stacks to have high efficiency in a structure of subpixels, which emit light of different colors, and can thus reduce a thickness between opposing electrodes to achieve low power consumption, improve pure color characteristics, and maintain high efficiency.

It is to be understood that both the foregoing general description and the following detailed description of the present disclosure are exemplary and explanatory and are intended to provide further explanation of the disclosure as claimed.

## BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:

FIG. 1 is a cross-sectional view showing a light emitting device according to one or more embodiments of the present disclosure;

FIG. 2 is a cross-sectional view showing a second light emitting device having a light emitting layer arrangement corresponding to a second order resonance distance and the light emitting device according to one or more embodiments of the present disclosure;

FIG. 3 is a graph showing distances between a first electrode and light emitting layers and distances between the light emitting layers and a second electrode in the light emitting device according to one or more embodiments of the present disclosure;

FIG. 4 is a graph comparatively showing distances between a first electrode and light emitting layers and distances between the light emitting layers and a second electrode in a third light emitting device corresponding to a first order resonance distance, the second light emitting device corresponding to the second order resonance distance, a fourth light emitting device corresponding to a third order resonance distance, and the light emitting device according to one or more embodiments of the present disclosure;

FIG. 5A is a graph showing the distance between the first electrode and the light emitting layer and the distance between the light emitting layer and the second electrode in the third light emitting device corresponding to the first order resonance distance;

FIG. 5B is a graph showing the distances between the first electrode and the light emitting layers and the distances between the light emitting layers and the second electrode in the second light emitting device corresponding to the second order resonance distance;

FIG. 5C is a graph showing the distances between the first electrode and the light emitting layers and the distances between the light emitting layers and the second electrode in the fourth light emitting device corresponding to the third order resonance distance;

FIG. 6 is a cross-sectional view showing a light emitting display device according to one or more embodiments of the present disclosure;

FIG. 7A is a contour map showing distances between blue light emitting layers and a first electrode and distances between the blue light emitting layers and a second electrode in a blue light emitting device of FIG. 6;

FIG. 7B is a graph showing efficiency according to a distance from the second electrode depending on the thickness of a hole transporting common layer in an $m^{th}$ light emitting stack of the blue light emitting device of FIG. 7A;

FIG. 8A is a contour map showing distances between green light emitting layers and a first electrode and distances between the green light emitting layers and a second electrode in a green light emitting device of FIG. 6;

FIG. 8B is a graph showing efficiency according to a distance from the second electrode depending on the thickness of a hole transporting common layer in an $m^{th}$ light emitting stack of the green light emitting device of FIG. 8A;

FIG. 9A is a contour map showing distances between red light emitting layers and a first electrode and distances between the red light emitting layers and a second electrode in a red light emitting device of FIG. 6;

FIG. 9B is a graph showing efficiency according to a distance from the second electrode depending on the thickness of a hole transporting common layer in an $m^{th}$ light emitting stack of the red light emitting device of FIG. 9A; and

FIG. 10 is a cross-sectional view showing a light emitting display device according to one embodiment of the present disclosure.

## DETAILED DESCRIPTION OF THE EMBODIMENTS

Reference will now be made in detail to example embodiments of the present disclosure, examples of which are illustrated in the accompanying drawings. Wherever possible, the same reference numbers will be used throughout the drawings to refer to the same or like parts, unless otherwise specified.

Advantages and features of the present disclosure, and a method of achieving the advantages and features will become apparent with reference to the example embodiments described herein in detail together with the accompanying drawings. The present disclosure should not be construed as limited to the example embodiments as disclosed below, and can be embodied in various different forms. Thus, these example embodiments are set forth only to make the present disclosure sufficiently complete, and to assist those skilled in the art to fully understand the scope of the present disclosure. The protected scope of the present disclosure is defined by the claims and their equivalents.

In the following description of the present disclosure, where the detailed description of the relevant known steps, elements, functions, technologies, and configurations can unnecessarily obscure an important point of the present disclosure, a detailed description of such steps, elements, functions, technologies, and configurations maybe omitted. In addition, the names of elements used in the following description are selected in consideration of clarity of description of the disclosure, and can differ from the names of elements of actual products. Furthermore, in the following detailed description of the present disclosure, numerous specific details are set forth in order to provide a sufficiently thorough understanding of the present disclosure. However, it will be understood that the present disclosure can be practiced without these specific details. In other instances, known methods, procedures, components, and circuits have not been described in detail so as not to unnecessarily obscure aspects of the present disclosure.

The shapes, sizes, ratios, angles, numbers, and the like, which are illustrated in the drawings to describe various example embodiments of the present disclosure are merely given by way of example. The disclosure is not limited to the illustrations in the drawings.

In the present disclosure, where terms such as "including," "having," "comprising," and the like are used, one or more components can be added, unless the term, such as "only," is used. As used herein, the term "and/or" includes a single associated listed item and any and all of the combinations of two or more of the associated listed items.

An expression such as "at least one of" when preceding a list of elements can modify the entire list of elements and may not modify the individual elements of the list. The term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, and the third element.

The terminology used herein is to describe particular aspects and is not intended to limit the present disclosure. As used herein, the terms "a" and "an" used to describe an element in the singular form is intended to include a plurality of elements. An element described in the singular form is intended to include a plurality of elements, and vice versa, unless the context clearly indicates otherwise. Further, the term "can" fully encompasses all the meanings and coverages of the term "may."

In construing a component or numerical value, the component or the numerical value is to be construed as including an error or tolerance range even where no explicit description of such an error or tolerance range is provided.

In describing the various example embodiments of the present disclosure, where the positional relationship between two elements is described using terms, such as "on", "above", "over", "below", "under" and "next to", at least one intervening element can be present between the two elements, unless "immediate(ly)" or "direct(ly)" or "close(ly) is used. It will be understood that when an element or layer is referred to as being "connected to", or "coupled to" another element or layer, it can be directly connected to or coupled to the other element or layer, or one or more intervening elements or layers can be present.

In describing the various example embodiments of the present disclosure, when terms such as "after," "subsequently," "next," and "before," are used to describe the temporal relationship between two events, another event can occur therebetween, unless a more limiting term, such as "just," "immediate(ly)," or "directly" is used.

In describing the various example embodiments of the present disclosure, terms such as "first" and "second" can be used to describe a variety of components. These terms aim to distinguish the same or similar components from one another and do not limit the components and may not define order or sequence. Accordingly, throughout the disclosure, a "first" component can be the same as a "second" component within the technical concept of the present disclosure, unless specifically mentioned otherwise.

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

As used herein, the term "doped" layer refers to a layer including a first material and a second material (for example, n-type and p-type materials, or organic and inorganic substances) having physical properties different from the first material. Apart from the differences in properties, the first and second materials can also differ in terms of their amounts in the doped layer. For example, the host material can be a major component while the dopant material can be a minor component. The first material accounts for most of the weight of the doped layer. The second material can be added in an amount less than 30% by weight, based on a total weight of the first material in the doped layer. A "doped" layer can be a layer that is used to distinguish a host material from a dopant material of a certain layer, in consideration of the weight ratio. For example, if all of the materials constituting a certain layer are organic materials, at least one of the materials constituting the layer is n-type and the other is p-type, when the n-type material is present in an amount of less than 30 wt%, or when the p-type material is present in an amount of less than 30 wt%, the layer is considered to be a "doped" layer.

Further, the term "undoped" refers to layers that are not "doped". For example, a layer can be an "undoped" layer when the layer contains a single material or a mixture including materials having the same properties as each other. For example, if at least one of the materials constituting a certain layer is p-type and none of the materials constituting the layer are n-type, the layer is considered to be an "undoped" layer. For example, if at least one of the materials constituting a layer is an organic material and none of the materials constituting the layer are inorganic materials, the layer is considered to be an "undoped" layer.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the present disclosure, a stack refers to a unit structure including common layers including a hole transport layer and an electron transport layer, and a light emitting layer disposed between the hole transport layer and the electron transport layer, unless limited to a specific structure in an embodiment. The common layers can further include a hole injection layer, an electron blocking layer, a hole blocking layer, and an electron injection layer, and can further include other functional layers depending on the structure or design of a light emitting device.

Now, various embodiments of the present disclosure will be discussed with reference to the drawings. All the components of each device and each apparatus according to all embodiments of the present disclosure are operatively coupled and configured.

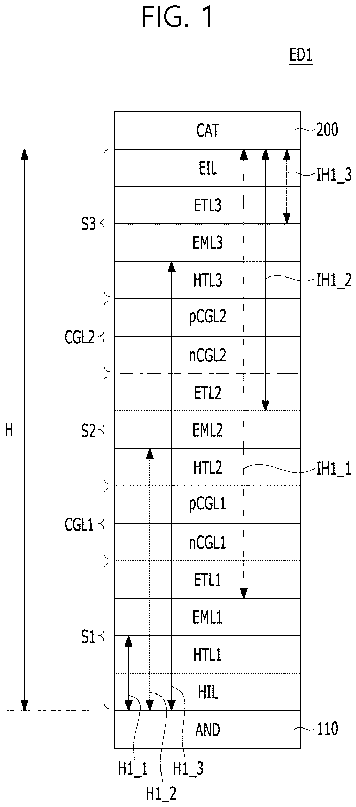

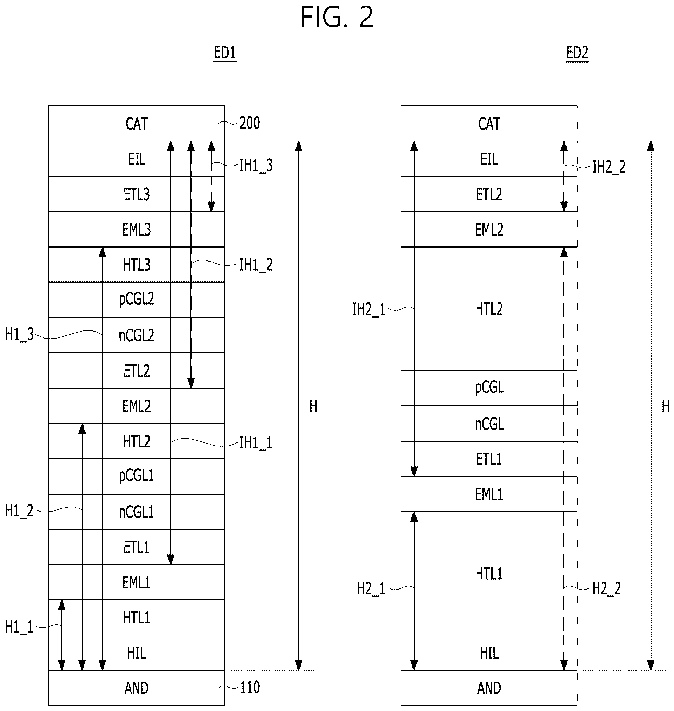

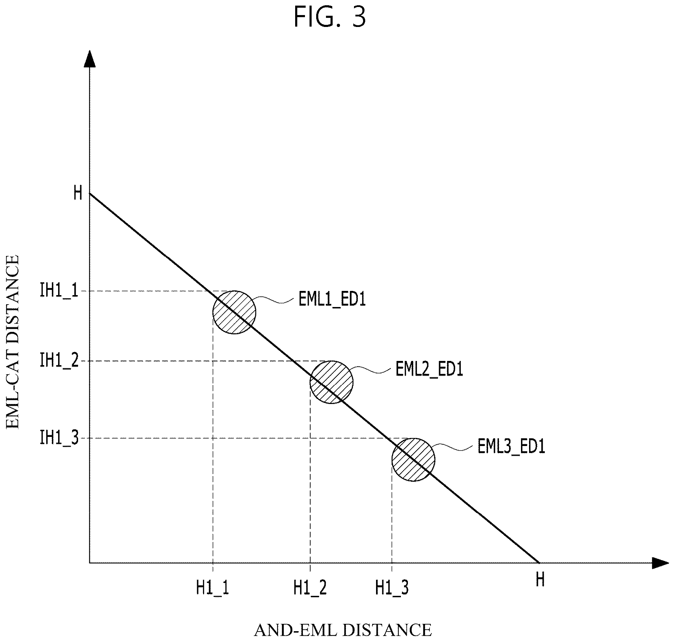

FIG. 1 is a cross-sectional view showing a light emitting device according to one embodiment of the present disclosure. FIG. 2 is a cross-sectional view showing a second light emitting device having a light emitting layer arrangement corresponding to a second order resonance distance and the light emitting device according to one embodiment of the present disclosure. FIG. 3 is a graph showing distances between a first electrode and light emitting layers and distances between the light emitting layers and a second electrode in the light emitting device according to one embodiment of the present disclosure.

As shown in FIG. 1, a light emitting device ED1 according to one embodiment of the present disclosure includes a first electrode 110 and a second electrode 200 configured to face each other, and first to $m^{th}$ light emitting stacks S1, S2, and S3 provided between the first electrode 110 and the second electrode 200, each including a light emitting layer configured to emit light of the same color. Here, m is a natural number of 3 or more.

One of the first electrode 110 and the second electrode 200 can be an anode, and the other can be a cathode. FIG. 1 shows a case in which the first electrode 110 is an anode AND and the second electrode 200 is a cathode CAT, the embodiments of the present disclosure are limited thereto. A light emitting device according to another embodiment can include the first electrode 110 as a cathode and the second electrode 200 as an anode.

One of the first electrode 110 and the second electrode 200 can be connected to a thin film transistor of each subpixel provided on a substrate and receive a driving voltage depending on a gray scale, and the other of the first electrode 110 and the second electrode 200 can receive a common voltage applied from a plurality of subpixels.

One of the first electrode 110 and the second electrode 200 can be a reflective electrode, and the other of the first electrode 110 and the second electrode 200 can be a transparent electrode or a transflective electrode. If the first electrode 110 is a reflective electrode and the second electrode 200 is a transparent electrode or a transflective electrode, the light emitting device can be a top emission type light emitting device. If the first electrode 110 is a transparent electrode and the second electrode 200 is a reflective electrode, the light emitting device can be a bottom emission type light emitting device. In one embodiment of the present disclosure, each of the first electrode 110 and the second electrode 200 can be formed as a non-reflective electrode, so that the light emitting device can emit light from both sides thereof. If the first electrode 110 is a reflective electrode, the reflective electrode can have a single layer or a plurality of layers. For example, the reflective electrode can include a stacked structure of ITO/Ag or Ag alloy layer/ITO, or Ag or Ag alloy layer/ITO, without being limited thereto. Embodiments are not limited thereto. As an example, the first electrode 110 and/or the second electrode 200 may be any one of a reflective electrode, a non-reflective electrode, a transparent electrode and a transflective electrode, without being limited thereto.

First to third light emitting stacks S1, S2, and S3 can be included between the first and second electrodes 110 and 200, and each of the first to third light emitting stacks S1, S2, and S3 can include a plurality of layers. All of a plurality of stacks provided between the first and second electrodes 110 and 200 can be referred to as an intermediate layer. Here, a plurality of layers included in the intermediate layer can be organic layers or inorganic layers. Some of the plurality of organic layers included in the first to third light emitting stacks S1, S2, and S3 can further include metals or an inorganic material other than metals. The inorganic material other than metals can be provided independently in some of the plurality of layers, or can form a complex with an organic material.

The light emitting device ED1 according to one embodiment of the present disclosure includes three or more light emitting stacks. As an example, the light emitting device ED1 may include three or more light emitting stacks which emit light of the same color to improve pure color efficiency. For example, light emitting layers EML1, EML2, and EML3 of the respective overlapping light emitting stacks S1, S2, and S3 are light emitting layers which emit light of the same color. For example, each of the first to third light emitting stacks S1, S2, and S3 which overlap in a red subpixel includes a light emitting layer which emits red light, each of the first to third light emitting stacks S1, S2, and S3 which overlap in a green subpixel includes a light emitting layer which emits green light, and each of the first to third light emitting stacks S1, S2, and S3 which overlap in a blue subpixel includes a light emitting layer which emits blue light. Embodiments are not limited thereto. As an example, each of the first to third light emitting stacks S1, S2, and S3 which overlap in a subpixel of another color other than red, green or blue (e.g., cyan, magenta, yellow, etc.) may include a light emitting layer which emits light of the another color.

FIG. 1 shows an example in which three light emitting stacks are illustrated, but the embodiments of the present disclosure are not limited thereto, and can include four or more light emitting stacks. Charge generation layers CGL1 and CGL2 are provided between the respective light emitting stacks S1, S2, and S3 to distinguish the light emitting stacks S1, S2, and S3 from each other. The charge generation layers CGL1 and CGL2 are located between two adjacent light emitting stacks S1, S2, and S3. As shown in FIG. 1, if the light emitting device ED1 includes three light emitting stacks between the first and second electrodes 110 and 200, two charge generation layers can be provided between the first and second electrodes 110 and 200. However, the light emitting device according to one embodiment of the present disclosure is not limited to FIG. 1. If the light emitting device includes four light emitting stacks between the first and second electrodes 110 and 200, three charge generation layers can be provided between the first and second electrodes 110 and 200. On the assumption that the number of light emitting stacks provided between the first and second electrodes 110 and 20 is m (m being a natural number of 3 or more), the number of charge generation layers provided between the first and second electrodes 110 and 200 is (m-1).

The first light emitting stack S1 can include a hole injection layer HIL, a first hole transport layer HTL1, a first light emitting layer EML1, and/or a first electron transport layer ETL1, without being limited thereto.

The second light emitting stack S2 can include a second hole transport layer HTL2, a second light emitting layer EML2, and/or a second electron transport layer ETL2, without being limited thereto.

The third light emitting stack S3 can include a third hole transport layer HTL3, a third light emitting layer EML3, a third electron transport layer ETL3, and an electron injection layer EIL.

The first to third light emitting stacks S1, S2, and S3 include the hole transport layers HTL1, HTL2, and HTL3 under the first to third light emitting layers EML1, EML2, and EML3 to transmit holes to the first to third light emitting layers EML1, EML2, and EML3 provided in the first to third light emitting stacks S1, S2, and S3, respectively, and include the electron transport layers ETL1, ETL2, and ETL3 to transmit electrons to first to third light emitting layers EML1, EML2, and EML3.

In the first light emitting stack S1 in contact with the first electrode 110, holes are injected into the intermediate layer from an electrode material of the first electrode 110 and, in order to lower a barrier, the first light emitting stack S1 can further include the hole injection layer HIL compared to other light emitting stacks S2 and S3, without being limited thereto. As an example, the hole injection layer HIL may be omitted depending on the design.

In the third light emitting stack S3 in contact with the second electrode 200, electrons are injected into an organic layer from an electrode material of the second electrode 220 and, in order to lower a barrier, the third light emitting stack S3 can further include the electron injection layer EII, compared to other light emitting stacks S1 and S2, without being limited thereto. As an example, the hole injection layer HIL may be omitted depending on the design. If the light emitting device according to one embodiment of the present disclosure has four or more light emitting stacks between the first electrode 110 and the second electrode 200, the last light emitting stack in contact with the second electrode 200 can include the electron injection layer EIL.

A first charge generation layer CGL1 is provided between the first light emitting stack S1 and the second light emitting stack S2 adjacent to each other, and a second charge generation layer CGL2 is provided between the second light emitting stack S2 and the third light emitting stack S3 adjacent to each other.

The first charge generation layer CGL1 can include an n-type charge generation layer nCGL1 and a p-type charge generation layer pCGL1. The second charge generation layer CGL2 can include an n-type charge generation layer nCGL2 and a p-type charge generation layer pCGL2. The p-type charge generation layers pCGL1 and pCGL2 can include a p-type dopant in a host material. The n-type charge generation layers nCGL1 and nCGL2 can include an n-type dopant in a host material. The p-type charge generation layers pCGL1 and pCGL2 can include the same material as a material included in the hole injection layer, and can contribute to hole generation. Alternatively, the p-type charge generation layers pCGL1 or pCGL2 may include a material different from a material included in the hole injection layer. The p-type charge generation layers pCGL1 and pCGL2 can include an inorganic material including at least one of tungsten oxide ($WO_x$), molybdenum oxide ($MoO_x$), beryllium oxide ($Be_2O_3$), and vanadium oxide ($V_2O_5$), without being limited thereto. Alternatively, the p-type charge generation layers pCGL1 and pCGL2 can be formed of an organic material, for example, including at least one of NPD, HAT-CN, F4TCNQ, TPD, TNB, TCTA, N,N'-dioctyl-3,4,9,10-perylenedicarboximide (PTCDI-C8), and indacene derivatives), without being limited thereto. In some cases, the p-type charge generation layers pCGL1 and pCGL2 can further include a separate organic or inorganic p-type dopant in addition to the above-described inorganic material or organic material. The p-type dopant can be a single element, such as boron, or a low molecular or high molecular weight organic dopant that contributes to hole transport. The n-type charge generation layers nCGL1 and nCGL2 can include an electron transport host and an inorganic dopant, such as an alkali metal or an alkaline earth metal, without being limited thereto.

As shown in FIG. 1, the light emitting device ED1 according to one embodiment of the present disclosure has a distance between the first and second electrodes 110 and 200 as a vertical distance H, and includes the three light emitting stacks S1, S2, and S3.

Here, in the light emitting device of FIG. 1 according to one embodiment of the present disclosure, the vertical distance H is set to a resonance distance of the second, which is one order less than 3, i.e., the number of the light emitting stacks S1, S2, and S3, or less order.

When the light emitting layers EML1, EML2, and EML3 in the light emitting device ED1 emit light, resonance, in which the emitted light of a certain wavelength is repeatedly reflected and re-reflected between the first electrode 110 and the second electrode 200, occurs, and finally, the light of the certain wavelength passes through a transparent or transmissive electrode.

Resonance occurs under the condition of Equation 1 below. m indicates the order number at resonance.

[Equation 1]

$$2nd = m\lambda$$

with n being a refractive index, d being a thickness of an area where resonance occurs, m being an integer, and $\lambda$ being a wavelength corresponding to resonance.

In Equation 1, n is the average refractive index of intermediate layer including a plurality of layers provided between the first and second electrodes. For example, the average refractive index of the intermediate layer including all of the plurality of layers provided between the first and second electrodes facing each other can be 1.7 to 2.0.

In general, if a specific functional layer is not provided between the first and second electrodes facing each other, the resonance distance d can be calculated in direct proportion to the wavelength $\lambda$ of the light emitting layer and the order number m of resonance and in inverse proportion to the average refractive index n of the intermediate layer between the first and second electrodes according to Equation 1. For example, if the central wavelength $\lambda$ of blue light is set to approximately 450 nm, the order number m is set to 2, and the average refractive index n of the organic layer is set to approximately 1.8, the resonance distance d is derived as a value equivalent to 250 nm (=2500 Å). If three light emitting stacks are arranged in proportion to a third order resonance distance, the resonance distance d between the first and second electrodes is 375 nm based on Equation 1 above. However, when light emitting stacks are provided in a number corresponding to the order number of resonance, the resonance distance of a light emitting device having a plurality of light emitting stacks increases, and this means that the vertical distance between the first electrode and the second electrode increases. Such an increase in the vertical distance between the first electrode and the second electrode means that the thickness of a dielectric between the electrodes facing each other increases, and further means that a driving voltage to drive the light emitting device increases.

The light emitting device according to one embodiment of the present disclosure sets the vertical distance H between the first and second electrodes 110 and 200 corresponding to the order number which is less than the number of light emitting stacks to increase the efficiency of the light emitting device without increasing the driving voltage. As an example, the light emitting device ED1 shown in FIG. 1 has three light emitting stacks between the first and second electrodes 110 and 200, and sets the vertical distance H to correspond to the second resonance order.

Further, the light emitting device according to one embodiment of the present disclosure is characterized in that distances H1_1, H1_2, and H1_3 between the first electrode 110 and the light emitting layers EML1, EML2, and EML3 and distances IH1_1, IH1_2, and IH1_3 between the second electrode 200 and the light emitting layers EML1, EML2, and EML3 are set to achieve optimal light emission of each light emitting layer within the reduced vertical distance H.

The light emitting device shown in FIG. 1 has three light emitting stacks between the first and second electrodes 110 and 200 so that the three light emitting stacks are arranged within the resonance distance of the second order to allow each of the plurality of light emitting stacks to emit light without increasing a layer thickness between the first and second electrodes 110 and 200, thereby increasing luminous efficacy (high efficiency). In addition, the light emitting device according to one embodiment of the present disclosure can increase pure color efficiency due to the increased number of light emitting stacks, and can improve luminous efficiency without increasing a driving voltage because the thickness between the first and second electrodes 110 and 200 is not increased compared to the increased number of light emitting stacks.

Meanwhile, because the resonance distance d is in direct proportion to the wavelength λ according to Equation 1, a blue light emitting device which emits blue light, a green light emitting device which emits green light, and a red light emitting device which emits red light can have different resonance distances.

The blue light emitting device includes blue light emitting layers having an emission peak at 440 nm to 550 nm, the green light emitting device includes green light emitting layers having an emission peak at 510 nm to 590 nm, and the red light emitting device includes red light emitting layer shaving an emission peak at 600 nm to 640 nm. In one embodiment of the present disclosure shown in FIG. 1, when each of the blue light emitting device provided in the blue subpixel, the green light emitting device provided in the green subpixel, and the red light emitting device provided in the red subpixel has three light emitting stacks arranged within the resonance distance of the second order, the respective vertical distances H between the first and second electrodes 110 and 200 can be different, as set forth in Table 1 below. As the emission wavelength λ increases, the vertical distance H increases. The green light emitting device and the red light emitting device can have an increased vertical distance H compared to the blue light emitting device. As an example, the green light emitting device and the red light emitting device can further use a hole transport auxiliary layer compared to the blue light emitting device, or can have a different thickness of the light emitting layer and/or a different thickness of the hole transport auxiliary layer from the blue light emitting device, thereby being capable of increasing the vertical distance H compared to the blue light emitting device, without being limited thereto.

Table 1]

|  | Blue light emitting device | Green light emitting device | Red light emitting device |
|---|---|---|---|
| H[Å] | 2500±200 | 2800±200 | 3200±200 |

Table 1 shows the vertical distances H between the first and second electrodes 110 and 200 when the three light emitting stacks of each of the blue light emitting device, the green light emitting device, and the red light emitting device are disposed within the resonance distance of the second order, and the vertical distances H can be further increased if four or more light emitting stacks are provided between the first and second electrodes 110 and 200.

In addition, 200 Å in the vertical distances H in Table 1 indicates an error range, without being limited thereto.

As shown in FIGs. 1 to 3, in the light emitting device ED1 according to one embodiment of the present disclosure, the distances H1_1, H1_2, and H1_3 between the first electrode 110 and the light emitting layers EML1, EML2, and EML3 and the distances IH1_1, IH1_2, and IH1_3 between the second electrode 200 and the light emitting layers EML1, EML2, and EML3 are adjusted to achieve optimal light emission of each light emitting layer.

Here, the hole injection layer HIL and the first hole transport layer HTL1 are included in the distance H1_1 between the first electrode 110 and the first light emitting layer EML1.

Together with the hole injection layer HIL and the first hole transport layer HTL1, the first light emitting layer EML1, the first electron transport layer ETL1, the first charge generation layer CGL1, and the second hole transport layer HTL2 are included in the distance H1_2 between the first electrode 110 and the second light emitting layer EML2. For example, in addition to the components HIL and HTL1 included in the distance H1_1 between the first electrode 110 and the first light emitting layer EML1, the first light emitting layer EML1, the first electron transport layer ETL1, the first charge generation layer CGL1, and the second hole transport layer HTL2 can be further included in the distance H1_2 between the first electrode 110 and the second light emitting layer EML2.

In addition to the components HIL, HTL1, EML1, ETL1, CGL1, and HTL2 included in the distance H1_2 between the first electrode 110 and the second light emitting layer EML2, the second light emitting layer EML2, the second electron transport layer ETL2, the second charge generation layer CGL2, and the third hole transport layer HTL3 are further included in the distance H1_3 between the first electrode 110 and the third light emitting layer EML3.

Here, the electron injection layer EIL and the third electron transport layer ETL3 are included in the distance IH1_3 between the second electrode 200 and the third light emitting layer EML3.

Together with the electron injection layer EIL and the third electron transport layer ETL3, the third light emitting layer EML3, the third hole transport layer ETL3, the second charge generation layer CGL2, and the second electron transport layer ETL2 are included in the distance IH1_2 between the second electrode 200 and the second light emitting layer EML2. For example, in addition to the components EIL and ETL3 included in the distance IH1_3 between the second electrode 200 and the third light emitting layer EML3, the third light emitting layer EML3, the third hole transport layer ETL3, the second charge generation layer CGL2, and the second electron transport layer ETL2 are included in the distance IH1_2 between the second electrode 200 and the second light emitting layer EML2.

In addition to the components EIL, ETL3, EML3, HTL3, CGL2, and ETL2 included in the distance IH1_2 between the second electrode 200 and the second light emitting layer EML2, the second light emitting layer EML2, the second hole transport layer HTL2, the first charge generation layer CGL1, and the first electron transport layer ETL1 are further included in the distance IH1_1 between the second electrode 200 and the first light emitting layer EML1.

Meanwhile, the light emitting device ED1 according to one embodiment of the present disclosure, defined as a first light emitting device ED1, and the second light emitting device ED2 in which two light emitting stacks are provided to correspond to the resonance distance of the second order will be comparatively described.

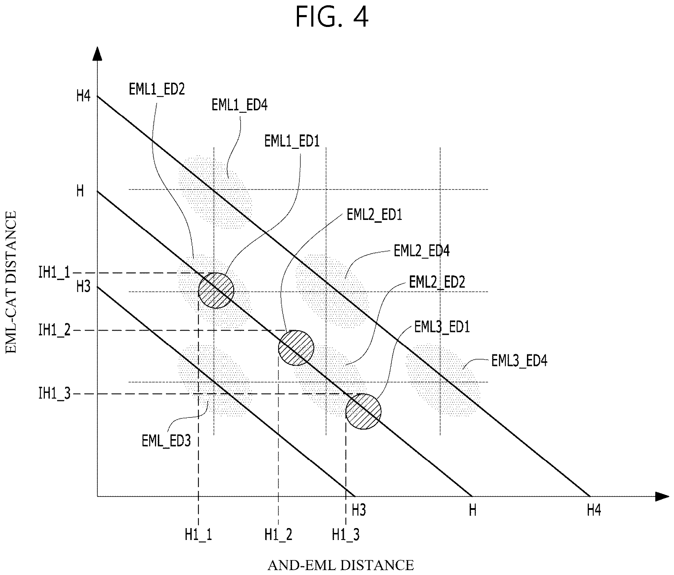

Referring to FIG. 2, since the vertical distance H of the three light emitting devices S1, S2, and S3 between the first and second electrodes AND and CAT in the first light emitting device ED1 is adjusted to the order number of the second order resonance distance, the distance H1_1 between the first electrode AND and the first light emitting layer EML1 in the first light emitting device ED1 is set to be smaller than a distance H2_1 between the first electrode AND and the first light emitting layer EML1 in the second light emitting device ED2 in which the two light emitting stacks are provided to correspond to the order number of the second order resonance distance. In addition, the distance H1_2 between the first electrode AND and the second light emitting layer EMI,2 in the first light emitting device ED1 is set to be smaller than a distance H2_2 between the first electrode AND and the second light emitting layer EML1 in the second light emitting device ED2 in which the two light emitting stacks are provided to correspond to the order number of the second order resonance distance. Since the vertical distance H between the first and second electrodes AND and CAT in the first light emitting device ED1 is smaller than a vertical distance H4 between first and second electrodes AND and CAT of a fourth light emitting device ED4 (in FIG. 4) in which three light emitting stacks are provided to correspond to the order number of the three order resonance distance, the respective distances H1_1, H1_2, and H1_3 between the first electrode AND and the first emitting layer EMI,1, the second emitting layer EML2, and the third emitting layer EML3 of the first light emitting device ED1, are set to be smaller than distances between the first electrode AND and respective light emitting layers EML1_ED4, EML2_ED4, and EML3_ED4 of the fourth light emitting device ED4 (in FIG. 4). Further, the respective distances IH1_3, IH1_2, and IH1_1 between the second electrode CAT and the third emitting layer EML3, the second emitting layer EML2, and the first emitting layer EML1 of the first light emitting device ED1 are set to be smaller than distances between the second electrode CAT and the respective light emitting layers EML3_ED4, EML2_ED4, and EML1_ED4 of the fourth light emitting device ED4.

For reference, the second light emitting device ED2 sets the vertical distance H so that the two light emitting stacks between the first and second electrodes AND and CAT are arranged to correspond to the order number of the second order resonance, and the vertical distance H of the second light emitting device ED2 is the same as the vertical distance H between the first and second electrodes AND and CAT of the first light emitting device ED1 according to one embodiment of the present disclosure having the structure shown in FIG. 1. FIG. 2 comparatively shows the first light emitting device ED1 and the second light emitting device ED2.

The second light emitting device ED2 includes a charge generation layer including an n-type charge generation layer nCGL and a p-type charge generation layer pCGL, a first light emitting stack including a hole injection layer HIL, a first hole transport layer HTL1, a first light emitting layer EML1, and a first electron transport layer ETL1 between the first electrode AND and the n-type charge generation layer nCGL, and a second light emitting stack including a second hole transport layer HTL2, a second light emitting layer EML2, a second electron transport layer ETL2, and an electron injection layer between the p-type charge generation layer pCGL and the second electrode CAT. Since the second light emitting device ED2 has a smaller number of light emitting stacks, a distance between the first and second light emitting layers EML1 and EML2 can be greater than that of the first light emitting device ED1. Further, the distance H2_1 between the first electrode AND and the first light emitting layer EML1 of the second light emitting device ED2 can also be greater than the distance H1_1 between the first electrode AND and the first light emitting layer EMI,1. For example, the distances H1_1, H1_2, and H1_3 between the first electrode AND and the respective emitting layers EML1, EML2, and EML3 and the distances IH1_1, IH1_2, and IH1_3 between the second electrode CAT and the respective emitting layers EML1, EML2, and EML3 can be adjusted by adjusting the thicknesses of the hole transport layers HTL1, HTL2, and HTL3 of the respective light emitting stacks of the first light emitting device ED1 compared to the second light emitting device ED2. Embodiments are not limited thereto. As an example, the distances H1_1, H1_2, and HI_3 between the first electrode AND and the respective emitting layers EML1, EML2, and EML3 and the distances IH1_1, IH1_2, and IH1_3 between the second electrode CAT and the respective emitting layers EML1, EML2, and EML3 may be adjusted by adjusting the thicknesses of the hole transport layers HTL1, HTL2, and HTL3 of the respective light emitting stacks of the first light emitting device ED1 and/or the thicknesses of the emitting layers EML1, EML2, and EML3 and/or the thicknesses of the charge generation layer CGL, and/or the thicknesses of the electron transport layers ETL1, ETL2, and ETL3 compared to the second light emitting device ED2, without being limited thereto. FIG. 2 shows one example in which, in addition to the hole transport layers HTL1, HTL2, and HTL3, the thicknesses of other common layers provided in common in the subpixels of different colors, for example, the electron transport layers ETL1, ETL2, and ETL3, the charge generation layer CGL: nCGL and pCGL, and the hole injection layer HIL, can be adjusted. In the subpixels of different colors, different vertical distances H are required, and accordingly, the light emitting devices in the subpixels of different colors can use functional layers selectively provided in certain subpixels in addition to the common layers or can adjust the thicknesses of the functional layers, or can adjust the thicknesses of the light emitting layers, or may adjust the thicknesses of at least one of the common layers provided in common in the subpixels of different colors.

For example, as shown in FIG. 1, if the distances H1_1, H1_2, and H1_3 between the first electrode AND and the respective emitting layers EML1, EML2, and EML3 and the distances IH1_1, IH1_2, and IH1_3 between the second electrode CAT and the respective emitting layers EML1, EML2, and EML3 are adjusted to produce optimal light emission by adjusting the thicknesses of the hole transport layers HTL1, HTL2, and HTL3 of the respective light emitting stacks S1, S2, and S3 of the first light emitting device ED1 according to one embodiment of the present disclosure, the thicknesses of the first hole transport layer HTL1, the second hole transport layer HTL2, and the third hole transport layer HTL3 can all be set to 300 Å or less, without being limited thereto. Compared to the thicknesses of the first and second hole transport layers HTL1 and HTL2 of the second light emitting device ED2 shown in FIG. 2, which are set to approximately 600 Å to 1000 Å, the thicknesses of the first to third hole transport layers HTL1, HTL2, and HTL3 can be reduced to 1/2 or less. Embodiments are not limited thereto. As an example, compared to the thicknesses of the first and second hole transport layers HTL1 and HTL2 of the second light emitting device ED2 shown in FIG. 2, the thicknesses of at least one or each of the first to third hole transport layers HTL1, HTL2, and HTL3 may be reduced to 3/4, 2/3 or less. As an example, only one or some of the first to third hole transport layers HTL1, HTL2, and HTL3 may be reduced compared to the thicknesses of the first and second hole transport layers HTL1 and HTL2 of the second light emitting device ED2 shown in FIG. 2. As an example, the thicknesses of the first hole transport layer HILI, the second hole transport layer HTL2, and the third hole transport layer HTL3 may be set to be the same as or different from each other.

The thicknesses of the first hole transport layer HTL1, the second hole transport layer HTL2, and the third hole transport layer HTL3 can all be 300 Å or less. In addition, the second hole transport layer HTL2, which influences both the position of the second emitting layer EML2 and the position of the third emitting layer EML3, can be thinnest among the first to third hole transport layers HTL1, HTL2, and HTL3. Further, the first light emitting device ED1 according to one embodiment of the present disclosure requires to secure a designated thickness to achieve the effects of stabilizing interfaces and reducing a hole injection barrier by stacking the common layers on the first electrode AND, and the thickness of the first hole transport layer HTL1 of the first light emitting stack S1 can be greater than the thickness of the second hole transport layer HTL2 of the second light emitting stack S2. For example, the thickness of the second hole transport layer HTL2 of the second light emitting stack S2 can be smaller than the thickness of the first hole transport layer HTL1, and can be smaller than the thickness of the third hole transport layer HTL3, without being limited thereto.

In the first light emitting device ED1 according to one embodiment of the present disclosure, the third light emitting layer EML3 of the third light emitting stack S3 is located closer to the second electrode CAT compared to the second light emitting layer EML2 of the second light emitting device ED2, and accordingly, the first to third light emitting stacks S1, S2, and S3 can all be arranged within the reduced vertical distance between the first and second electrodes AND and CAT. For this purpose, the thickness of the third hole transport layer HTL3 of the third light emitting stack S3 can be greater than the thickness of the second hole transport layer HTL2 of the second light emitting stack S2. The thickness of the third hole transport layer HTL3 of the third light emitting stack S3 can be similar to or greater than the thickness of the first hole transport layer HTL1 of the first light emitting stack S1.

In some cases, for proximity between the second electrode CAT and the third light emitting layer EML3, the thickness of the third electron transport layer ETL3 of the third light emitting stack S3 can be smaller than at least one of the thicknesses of the first and second electron transport layers ETL1 and ETL2 of the first and second light emitting stacks S1 and S2.

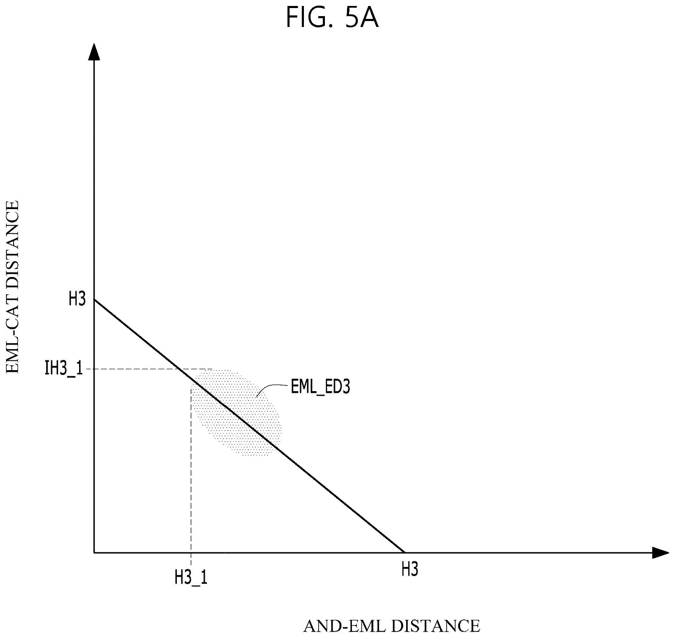

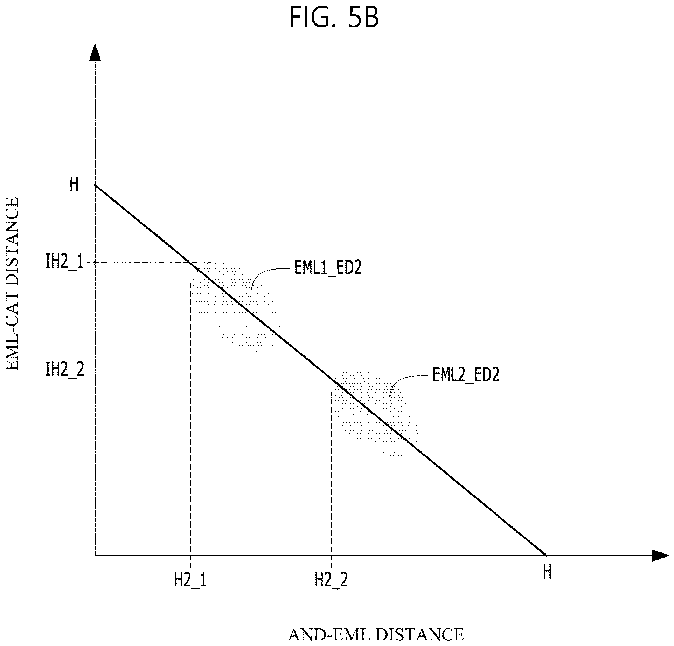

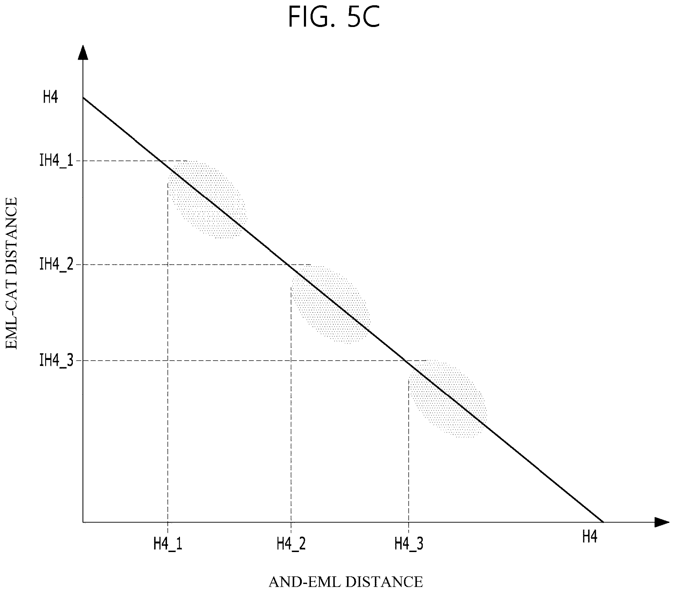

FIG. 4 is a graph comparatively showing distances between a first electrode and light emitting layers and distances between the light emitting layers and a second electrode in a third light emitting device corresponding to a first order resonance distance, the second light emitting device corresponding to the second order resonance distance, the fourth light emitting device corresponding to the third order resonance distance, and the light emitting device according to one embodiment of the present disclosure. FIG. 5A is a graph showing the distance between the first electrode and the light emitting layer and the distance between the light emitting layer and the second electrode in the third light emitting device corresponding to the first order resonance distance. FIG. 5B is a graph showing the distances between the first electrode and the light emitting layers and the distances between the light emitting layers and the second electrode in the second light emitting device corresponding to the second order resonance distance. FIG. 5C is a graph showing distances between the first electrode and the light emitting layers and distances between the light emitting layers and the second electrode in the fourth light emitting device corresponding to the third order resonance distance.

In FIG. 4, compared to the first to third light emitting layers EML1_ED1, EML2_ED1, and EML3_ED1 of the first light emitting device ED1 according to one embodiment of the present disclosure shown in FIG. 1, the position of the light emitting layer EML_ED3 of the third light emitting device ED3 having a single light emitting stack, the positions of the respective light emitting layers EML1_ED2 and EML2_ED2 of the second light emitting device ED2 having two light emitting stacks corresponding to the second order resonance distance H, and the positions of the respective light emitting layers EML1_ED4, EML2_ED4, and EML3_ED4 of the fourth light emitting device ED4 having three light emitting stacks corresponding to the third order resonance distance H4 are shown.

The third light emitting device ED3 has the single light emitting stack between the first electrode AND and the second electrode CAT, and a hole injection layer, a hole transport layer, the light emitting layer, an electron transport layer, and an electron injection layer are sequentially provided between the first electrode AND and the second electrode CAT. As comparatively shown in FIG. 4, the vertical distance H3 between the first electrode AND and the second electrode CAT of the third light emitting device ED3 can be shorter than the vertical distances H and H4 of the first light emitting device ED1, the second light emitting device ED2, and the fourth light emitting device ED4, which have a plurality of light emitting stacks. The third light emitting device ED3 has the single light emitting layer EML_ED3 between the first and second electrodes AND and CAT, and the position of the light emitting layer EML_ED3 where the optimal cavity is generated can be obtained by adjusting a distance H3_1 between the first electrode AND and the light emitting layer EML_ED3 and a distance IH3_1 between the second electrode CAT and the light emitting layer EML_ED3 in correspondence to the first order resonance distance or the second order resonance distance.

As shown in FIG. 2, the vertical distance H between the first and second electrodes AND and CAT of the second light emitting device ED2 is the same as that of the first light emitting device ED1 according to one embodiment of the present disclosure. Unlike the first light emitting device ED1 having three light emitting stacks, the two light emitting stacks are arranged within the same vertical distance H, and thus, as shown in FIGs. 4 and 5B, the distance between the first and second light emitting layers EML1_ED2 and EML1_ED2 of the second light emitting device ED2 is greater than the distance between two adjacent light emitting layers EML1_ED1 and EML2_ED1 or EML2_ED1 and EML2_ED3 of the first light emitting device ED1. The positions of the light emitting layers EML1_ED2 and EML2_ED2 of the second light emitting device ED2 where the optimal cavity is generated can be obtained by adjusting a distance H2_1 between the first electrode AND and the first light emitting layer EML1_ED2, a distance H2_2 between the first electrode AND and the second light emitting layer EML2_ED2, a distance IH2_1 between the second electrode CAT and the first light emitting layer EML1_ED2 and a distance IH2_2 between the second electrode CAT and the second light emitting layer EML2_ED2.

In some cases, if the X-axis represents the distance from the first electrode to each light emitting layer, i.e., an AND-EMI, distance, and the Y-axis represents the distance from the second electrode to each light emitting layer, i.e., a CAT-EMI, distance, the slopes indicated by virtual lines passing through the centers of the respective light emitting layers of the first light emitting device ED1 and the second light emitting device ED2 can be the same.

As shown in FIGs. 4 and 5C, the fourth light emitting device ED4 has three light emitting stacks, and respective light emitting layers EML1_ED4, EMD2_ED4, and EML3_ED4 are arranged to correspond to the third order resonance distance. Therefore, although the fourth light emitting device ED4 has the same number of light emitting stacks as the first light emitting device ED1 according to one embodiment of the present disclosure, the positions of at least one or all of the respective light emitting layers EML1_ED4, EMD2_ED4, and EML3_ED4 are different from those of the first light emitting device ED1, and the vertical distance H4 between the first and second electrodes AND and CAT of the fourth light emitting device ED4 is greater than that of the first light emitting device ED1. The positions of the light emitting layers EML1_ED4, EML2_ED4 and EML3_ED4 of the fourth light emitting device ED4 where the optimal cavity is generated can be obtained by adjusting a distance H4_1 between the first electrode AND and the first light emitting layer EML1_ED4, a distance H4_2 between the first electrode AND and the second light emitting layer EML2_ED4, a distance H4_3 between the first electrode AND and the third light emitting layer EML3_ED4, a distance IH4_1 between the second electrode CAT and the first light emitting layer EML1_ED4, a distance IH4_2 between the second electrode CAT and the second light emitting layer EML2_ED4, and a distance IH4_3 between the second electrode CAT and the third light emitting layer EML3_ED4. Referring to FIG. 4, it can be seen that the distance H4_1 between the first electrode AND and the first light emitting layer EML1_ED4, the distance H4_2 between the first electrode AND and the second light emitting layer EML2_ED4, and the distance H4_3 between the first electrode AND and the third light emitting layer EML3_ED4 of the fourth light emitting device ED4 are greater than the distance H1_1 between the first electrode AND and the first light emitting layer EML1_ED1, the distance H1_2 between the first electrode AND and the second light emitting layer EML2_ED1, and the distance H1_3 between the first electrode AND and the third light emitting layer EML3_ED1 of the first light emitting device ED1. Although the positions of the first, second, and third light emitting layers EML1_ED4, EML2_ED4, and EML3_ED4 can better match the optimal cavity conditions, the vertical distance H4 between the first and second electrodes AND and CAT can be about 375 nm in a blue light emitting device, and in this case, a driving voltage can greatly increase.

Recently, there is a growing need to drive display devices or electronic devices including light emitting devices with low power consumption due to environmental friendliness or the desire to be wearable or easily detachable. In addition, even when a display device is driven with low power consumption, the display device must meet the requirements for high luminance and high efficiency from the user's point of view. For this purpose, efforts are being made to change materials included in the light emitting device to other materials, but it is difficult to develop the materials in a short period of time. In the light emitting device according to one embodiment of the present disclosure, the number of light emitting stacks is increased within a limited vertical distance between the first and second electrodes, the positions of the light emitting layers in the increased number of light emitting stacks are adjusted by common layers related to hole injection and transport, and the contents of dopants related to hole injection and transports or the thicknesses of the light emitting layers are varied in the provided light emitting stacks, thereby being capable of achieving high efficiency while maintaining low power consumption.

This will be examined through tests below.

First, the pure color characteristics and efficiency generated when the thicknesses of the light emitting layers in the structure of the light emitting device ED1 of FIG. 1 according to one embodiment of the present disclosure are adjusted will be examined.

The following test was conducted on the light emitting device of a blue subpixel.

In Table 2, Test Example 1 EX1 indicates a case in which two light emitting stacks are provided between first and second electrodes and a third light emitting stack is not provided, like the second light emitting device ED2 of FIG. 2. In Test Example 1 EX1, a first light emitting layer EML1 and a second light emitting layer EML2 have the same thickness. Test Examples 2 to 7 EX2-EX7 are examples in which three light emitting stacks are provided between first and second electrodes, like the first light emitting device ED1, but the thickness ratios of light emitting layers are different.

Here, X indicates a reference thickness of the blue light emitting layers which was set to 200 Å to 250 Å, and 1.1X indicates a thickness of the blue light emitting layers which was set to 220 Å to 275 Å. The same tendency was shown in both a case in which the reference thickness X was set to 200 Å and the thickness 1.1X was set to 220 Å and a case in which the reference thickness X was set to 250 Å and the thickness 1.1X was set to 275 Å.

Table 2]

| Category | Thickness of light emitting layer | | | Blue | |
| --- | --- | --- | --- | --- | --- |
| | EML1 | EMI,2 | EML3 | CIEy | Luminance(Cd/A) |
| EX1 | X | X | None | 0.057 | 10.5 |
| EX2 | X | X | X | 0.058 | 11.0 |
| EX3 | 1.1X | X | X | 0.057 | 11.2 |
| EX4 | X | 1.1X | X | 0.058 | 11.2 |
| EX5 | X | X | 1.1X | 0.057 | 11.2 |
| EX6 | 1.1X | 1.1X | X | 0.058 | 11.3 |
| EX7 | X | 1.1X | 1.1X | 0.057 | 11.4 |

In Table 2, Test Example 1 EX1 indicates the case in which the two light emitting stacks are provided between the first and second electrodes and a third light emitting stack is not provided, like the second light emitting device ED2 of FIG. 2. In Test Example 1 EX1, the first light emitting layer EML1 and the second light emitting layer EMI,2 had the same thickness.

It can be seen that, compared to Test Example 1 EX1, all of Test Examples 2 to 7 EX2-EX7 in which the three light emitting stacks, each having a light emitting layer, like the first light emitting device ED1 according to one embodiment of the present disclosure, exhibited an improved luminance effect. For example, even if the vertical distances H between the first and second electrodes AND and CAT of the first light emitting device ED1 and the second light emitting device ED2 are the same, it can be seen that luminance was improved due to addition of an additional light emitting device EML3 to the structure of the second light emitting device ED2.

Meanwhile, a CIEy value is a standard for determining a degree of color purity, and it can be seen that, when two or more light emitting stacks were used in the blue subpixel, almost similar CIEy values were obtained. Table 2 shows results in which, when the number of light emitting layers was increased within a limited vertical distance at the same or similar level of blue light emission, luminance was improved.

Further, it can be seen that, compared to Test Example 2 EX2, in the Test Examples 3 to 7 EX3-EX7, when the thickness of at least one of the first light emitting layer EML1, the second light emitting layer EMI,2, and the third light emitting layer EML3 were increased, luminance was further improved.

Further, it can be seen that, comparing Test Examples 3 to 5 EX3 to EX5 with Test Examples 6 and 7 EX6 and EX7, efficiency was further improved in Test Examples 6 and 7 EX6 and EX7 in which the thicknesses of two light emitting layers were increased than in Test Examples 3 to 5 EX3 to EX5 in which the thickness of one of the first to third light emitting layers EMI,1, EML2, and EML3 is increased. It can be seen that, compared to Test Example 6 EX6 in which the thicknesses of two light emitting layers EML1 and EMI,2 close to the first electrode AND were increased, Test Example 7 EX7 in which the thicknesses of two light emitting layers EMI,2 and EML3 close to the second electrode CAT were increased was most effective.

Through the above-described test, it can be seen that the first light emitting device ED1 according to one embodiment of the present disclosure having the vertical distance H between the first and second electrodes AND and CAT corresponding to the (m-1)$^{th}$ resonance order and including first to m$^{th}$ (m being a natural number of 3 or more) light emitting stacks S1, S2, and S3, each including a light emitting layer emitting light of the same color, can improve emission luminance while maintaining pure color characteristics, and can be implemented without increase in a driving voltage using the intermediate layer having the same thickness as that of the second light emitting device ED2 having the vertical distance H between the first and second electrodes AND and CAT corresponding to the (m-1)$^{th}$ resonance order and including (m-1) light emitting stacks. For example, the light emitting device according to one embodiment of the present disclosure can be driven with low power consumption to achieve high efficiency with the same power consumption, and can be continuously driven while reducing or minimizing increase in material costs, thereby being capable of exhibiting environmental, social, and governance (ESG) effects.

Hereinafter, pure color characteristics and efficiency generated when varying the contents of a p-type dopant included in the hole injection layer and the p-type charge generation layer in the structure of the light emitting device ED 1 of FIG. 1 according to one embodiment of the present disclosure will be examined.

In Table 3, Test Example 1 EX1 represents a case in which two light emitting stacks are provided between first and second electrodes and a third light emitting stack is not provided, like the second light emitting device ED2 of FIG. 2, and in this case, one p-type charge generation layer is provided between the first and second electrodes. The respective light emitting layers EMI, EM2, and EM3 provided in Test Example 1 EX1 and Test Examples 8 to 10 EX8, EX9, and EX10 are blue light emitting layers having the same thickness.

In Test Example 1 EX1 and Test Examples 8 to 10 EX8, EX9, and EX10, the hole injection layer and the p-type charge generation layers can include an inorganic material including at least one of tungsten oxide ($WO_x$), molybdenum oxide ($MoO_x$), beryllium oxide ($Be_2O_3$), or vanadium oxide ($V_2O_5$), or an organic material including at least one of NPD, HAT-CN, F4TCNQ, TPD, TNB, TCTA, N,N'-diocyl-3,4,9,10-perylenedicarboximide (PTCDI-C8), and indacene derivatives, as a host, and further include a p-type dopant.

In the following test, a "small" content of the p-type dopant means that the p-type dopant is included in a content of 4 wt% to 8 wt% in the hole injection layer or the charge generation layers, a "medium" content of the p-type dopant means that the p-type dopant is included in a content of 10 wt% to 13 wt% in the hole injection layer or the charge generation layers, and a "large" content of the p-type dopant means that the p-type dopant is included in a content of 20 wt% to 25 wt% in the hole injection layer or the charge generation layers. The following test was conducted on the light emitting device of the blue subpixel, and a p-type organic dopant was used as the p-type dopant. Embodiments are not limited thereto. As an example, the numeral value for the "small", "medium" and "large" content may be variously changed.

Table 3]

| Category | HIL/pCGL conditions (p-type dopant content) | | | Blue | |
|---|---|---|---|---|---|
| | HIL | pCGL1 | pCGL2 | CIEy | Luminance (Cd/A) |
| EX1 | Small | Medium | None | 0.057 | 10.5 |
| EX8 | Small | Medium | Small | 0.057 | 9.7 |
| EX9 | Small | Medium | Medium | 0.057 | 10.8 |
| EX10 | Small | Medium | Large | 0.058 | 11.0 |

As set forth in Table 3, when the content of the p-type dopant included in the hole injection layer HIL was smaller than the contents of the p-type dopant included in the p-type charge generation layers pCGL1 and pCGL2 provided between the light emitting stacks, luminance of a certain level or more was exhibited. Therefore, it is desirable that the content of the p-type dopant in the hole injection layer HIL be smaller than the contents of the p-type dopant included in the p-type charge generation layers pCGL1 and pCGL2 provided between the light emitting stacks.

For example, in the first light emitting device ED1 having the structure of FIG. 1, when the contents of the p-type dopant included in the first and second p-type charge generation layers pCGL1 and pCGL2 are greater than the content of the p-type dopant included in the hole injection layer HIL, as in Test Example 9 EX9 and Test Example 10 EX 10, luminance was improved.

In addition, compared to Test Example 9 EX9 in which the contents of the p-type dopant included in the first and second p-type charge generation layers pCGL1 and pCGL2 were the same, Test Example 10 EX10 in which the content of the p-type dopant included in the second p-type charge generation layer pCGL2 was increased compared to the first p-type charge generation layer pCGL1 exhibited improved luminance.

According to the above results, it can be seen that, when three or more light emitting stacks emitting light of the same color are provided, it is desirable that the content of the p-type dopant included in the hole injection layer HIL included in the first emitting stack S1 be smaller than the contents of the p-type dopant included in the p-type charge generation layers provided between the light emitting stacks, and the content of the p-type dopant in the p-type charge generation layer located at a relatively higher position be greater than the content of the p-type dopant in the p-type charge generation layer located at a relatively lower position.

The above description and tests show that, when three or more light emitting stacks are arranged within a limited vertical distance between first and second electrodes, excitons generated by recombination of holes and electrons in a light emitting device are placed in the optimal position by adjusting the contents of a p-type dopant included in a small amount compared to a host material in a hole injection layer, a hole transport layer, and p-type charge generation layers involved in hole injection and transport, adjusting the thicknesses of the hole transport layers, or adjusting the thickness ratio of light emitting layers in the respective light emitting stacks. Accordingly, efficiency can be further improved, and thus, a light emitting device which can be driven with low power consumption and have improved efficiency can be implemented.

Hereinafter, a light emitting display device including different subpixels according to one or more embodiments of the present disclosure will be described.

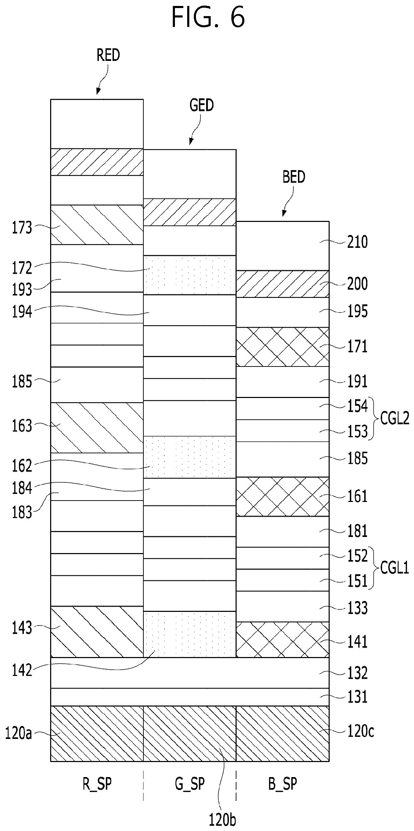

FIG. 6 is a cross-sectional view showing a light emitting display device according to one embodiment of the present disclosure.

As shown in FIG. 6, the light emitting display device according to one embodiment of the present disclosure includes first to third subpixels R-SP, G_SP, and B_SP which emit light of different colors.

A red light emitting device RED is provided in the first subpixel R_SP, a green light emitting device GED is provided in the second subpixel G_SP, and a blue light emitting device BED is provided in the third subpixel B_SP.

The red light emitting device RED includes a first electrode 120a and a second electrode 200 configured to face each other, first to m$^{th}$ (m being a natural number of 3 or more) light emitting stacks, each including light emitting layers 143, 163, and 173 emitting light of the same color, i.e., red light, and provided between the first electrode 120 and the second electrode 200, and first to (m-1)$^{th}$ charge generation layers CGL1 and CGL2 provided between adjacent light emitting stacks among the first to m$^{th}$ light emitting stacks. The emission peak of light emitted from the light emitting layers 143, 163, and 173 can be different for each light emitting stack depending on the thicknesses and components of the light emitting layers 143, 163, and 173. However, in the embodiment shown in FIG. 6, first to third light emitting layers 143, 163, and 173, which overlap each other, emit light within a red wavelength range to improve red light efficiency, and differences among the respective emission peaks of light emitted from the first to third light emitting layers 143, 163, and 173 may not exceed 10 nm, without being limited thereto.

FIG. 6 shows an example in which m is 3 and three light emitting stacks are provided between the first and second electrodes 120a and 200. However, the embodiments of the present disclosure are not limited thereto, and four or more light emitting stacks can be provided between the first and second electrodes 120a and 200.

In the light emitting display device according to FIG. 6, the vertical configurations of the red light emitting device RED, the green light emitting device GED, and the blue light emitting device BED will be sequentially described as follows.

That, the red light emitting device RED includes a hole injection layer 131, a first hole transport layer 132, a first red light emitting layer 143, a first electron transport layer 133, a first n-type charge generation layer 151, a first p-type charge generation layer 152, a second hole transport layer 181, a first red hole transport auxiliary layer 183, a second red light emitting layer 163, a second electron transport layer 185, a second n-type charge generation layer 153, a second p-type charge generation layer 154, a third hole transport layer 191, a second red hole transport auxiliary layer 193, a third red light emitting layer 173, a third electron transport layer 195, the second electrode 200, and a capping layer 210, on the first electrode 120a. The red light emitting device RED can further include an electron injection layer EIL between the third electron transport layer 195 and the second electrode 200.

The green light emitting device GED includes a hole injection layer 131, a first hole transport layer 132, a first green light emitting layer 142, a first electron transport layer 133, a first n-type charge generation layer 151, a first p-type charge generation layer 152, a second hole transport layer 181, a first green hole transport auxiliary layer 184, a second green light emitting layer 162, a second electron transport layer 185, a second n-type charge generation layer 153, a second p-type charge generation layer 154, a third hole transport layer 191, a second green hole transport auxiliary layer 194, a third green light emitting layer 172, a third electron transport layer 195, an electron injection layer EIL, a second electrode 200, and a capping layer 210, on a first electrode 120b.

The blue light emitting device DED includes a hole injection layer 131, a first hole transport layer 132, a first blue light emitting layer 141, a first electron transport layer 133, a first n-type charge generation layer 151, a first p-type charge generation layer 152, a second hole transport layer 181, a second blue light emitting layer 161, a second electron transport layer 185, a second n-type charge generation layer 153, a second p-type charge generation layer 154, a third hole transport layer 191, a third blue light emitting layer 171, a third electron transport layer 195, an electron injection layer EIL, a second electrode 200, and a capping layer 210, on a first electrode 120c.

The first n-type charge generation layer 151 and the first p-type charge generation layer 152 form a first charge generation layer CGL1, and the second n-type charge generation layer 153 and the second p-type charge generation layer 154 form a second charge generation layer CGL2. The first charge generation layer CGL1 and the second charge generation layer CGL2 are provided between adjacent light emitting stacks.

The first and second red hole transport auxiliary layers 183 and 193 and the first and second green hole transport auxiliary layers 184 and 194 can be formed of a hole transport material. To correspond to a red cavity of a relatively long wavelength, the first and second red hole transport auxiliary layers 183 and 193 are provided in the second and third light emitting stacks of the red light emitting device RED in order to increase a thickness compared to the second and third subpixels G_SP and B_SP. To correspond to a green cavity of a relatively longer wavelength than blue, the first and second green hole transport auxiliary layers 184 and 194 can be provided in the second subpixels G_SP. The first and second green hole transport auxiliary layers 184 and 194 can be thinner than the first and second red hole transport auxiliary layers 183 and 193, without being limited thereto. Alternatively, as an example, the thickness of at least one of the first and second green hole transport auxiliary layers 184 and 194 may be equal to or even greater than the first and second red hole transport auxiliary layers 183 and 193. As an example, at least one of the first and second green hole transport auxiliary layers 184 and 194 may be omitted. As an example, at least one additional hole transport auxiliary layer may be further provided in the red light emitting device RED.

In the light emitting display device according to one embodiment of the present disclosure shown in FIG. 1, a vertical thickness between the first electrode 120a, 120b, or 120c and the second electrode 200 of each light emitting device is adjusted to correspond to the second order. Accordingly, in each of the red light emitting device RED and the green light emitting device GED, in order to adjust the vertical distance between the first electrode 120a or 120b and the second electrode 200 to correspond to the second order, one of the first to third light emitting stacks may not be provided with a red hole transport auxiliary layer or a green hole transport auxiliary layer. FIG. 6 shows an example in which the first light emitting stacks adjacent to the first electrodes 120a and 120b are not provided with the hole transport auxiliary layer. Embodiments are not limited thereto. As an example, the first light emitting stacks adjacent to the first electrodes 120a and 120b may be also provided with the hole transport auxiliary layer. As an example, the second and/or third light emitting stacks may be not provided with the hole transport auxiliary layer. As long as the vertical distance between the first electrode 120a or 120b and the second electrode 200 may be adjusted to correspond to the second order, the number and positions of the hole transport auxiliary layer could be variously adjusted.

The hole injection layer 131, the first hole transport layer 132, the first electron transport layer 133, the first n-type charge generation layer 151, the first p-type charge generation layer 152, the second hole transport layer 181, the second electron transport layer 185, the second n-type charge generation layer 153, the second p-type charge generation layer 154, the third hole transport layer 191, the third electron transport layer 195, the electron injection layer EIL, the second electrode 200, and the capping layer 210 can be provided in common not only in the first subpixel R_SP but also in the second subpixel G_SP and the third subpixel B_SP. These layers are common layers, and have a continuous structure in a plane without distinction of subpixels, without being limited thereto. As an example, at least one or some of these common layers may have a continuous structure throughout the subpixels having the same or different colors. As an example, at least one or some of these common layers may have a continuous structure among sub-pixels having the same color, while have a discontinuous structure among sub-pixels have different colors, without being limited thereto.

The red light emitting device RED, the green light emitting device GED, and the blue light emitting device BED have different cavity characteristics required depending on each wavelength, the vertical distances between the first electrodes 120a, 120b, and 120c and the second electrode 200 can be varied, and differences among the vertical distances can be obtained by varying the thicknesses and/or the number of the hole transport auxiliary layers 183, 184, 193, and 194, without being limited thereto. In the light emitting display device according to one embodiment of the present disclosure, the vertical distance between the first electrode 120a, 120b, or 120c and the second electrode 200 of the light emitting devices RED, GED, or BED of each subpixels R_SP, G_SP, or B_SP corresponds to a resonance distance depending on the second order. To correspond to the vertical distance reduced compared to the number of light emitting stacks, one of the light emitting stacks provided in the red light emitting device RED and the green light emitting device GED may not have a hole transport auxiliary layer, without being limited thereto.

Meanwhile, the light emitting display device according to one embodiment of the present disclosure is not limited to the structure in which all of the first to third subpixels R_SP, G_SP, and B_SP emitting light of different colors have three light emitting stacks, as shown in FIG. 6. The first to third subpixels R_SP, G_SP, and B_SP can have four or more light emitting stacks. In this case, the light emitting device of each subpixel can include first to $m^{th}$ (m being a natural number of 3 or more) light emitting stacks provided between the first electrode 120a, 120b, or 120c and the second electrode 200 and including light emitting layers emitting light of the same color, and first to $(m-1)^{th}$ charge generation layers provided between adjacent light emitting stacks among the first to $m^{th}$ light emitting stacks, and all the light emitting layers provided in the first to $m^{th}$ light emitting stacks can be located in the resonance distance of the $(m-1)^{th}$ or less order (e.g., $(m-2)^{th}$, $(m-3)^{th}$ or less order), without being limited thereto. As an example, the first to third subpixels R_SP, G_SP, and B_SP may the same number of light emitting stacks, or different number of light emitting stacks.

In this case, the red light emitting device RED can include the first electrode 120a and the second electrode 200 facing each other, the first to $m^{th}$ (m being a natural number of 3 or more) light emitting stacks provided between the first electrode 120a and the second electrode 200, each light emitting stack including a light emitting layer emitting red light, and the first to $(m-1)^{th}$ charge generation layers provided between adjacent light emitting stacks among the first to $m^{th}$ light emitting stacks. The green red light emitting device GED can include the first electrode 120b and the second electrode 200 facing each other, the first to $m^{th}$ (m being a natural number of 3 or more) light emitting stacks provided between the first electrode 120b and the second electrode 200, each light emitting stack including a light emitting layer emitting green light, and the first to (m-1)th charge generation layers provided between adjacent light emitting stacks among the first to mth light emitting stacks. The blue light emitting device BED can include the first electrode 120c and the second electrode 200 facing each other, the first to mth (m being a natural number of 3 or more) light emitting stacks provided between the first electrode 120c and the second electrode 200, each light emitting stack including a light emitting layer emitting blue light, and the first to (m-1)th charge generation layers provided between adjacent light emitting stacks among the first to mth light emitting stacks.

Hereinafter, through tests, efficiency depending on a thickness between adjacent light emitting layers in each of the blue light emitting device, the green light emitting device, and the red light emitting device in the light emitting display device having the structure of FIG. 6 will be examined.

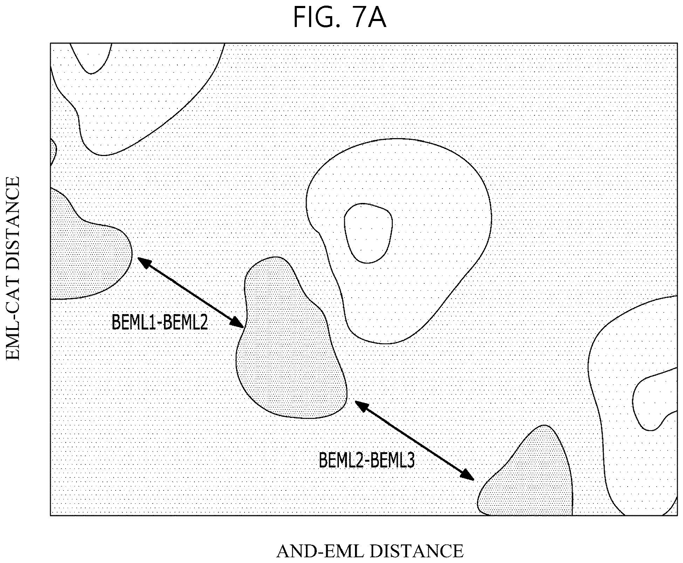

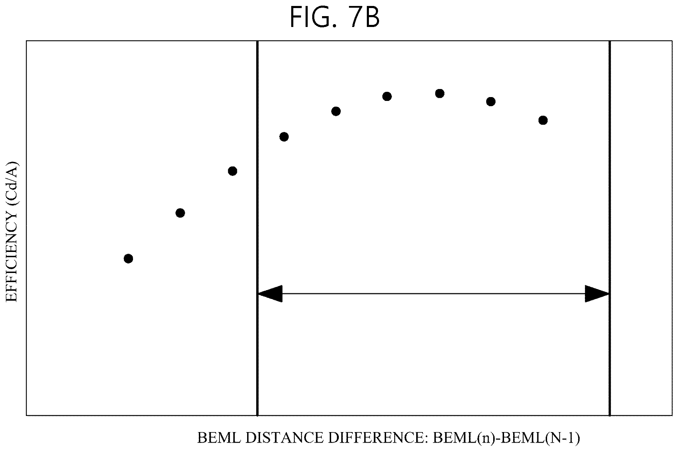

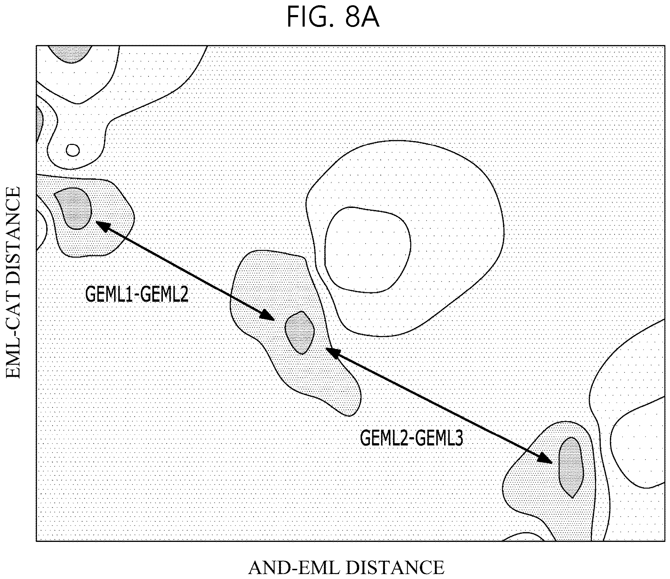

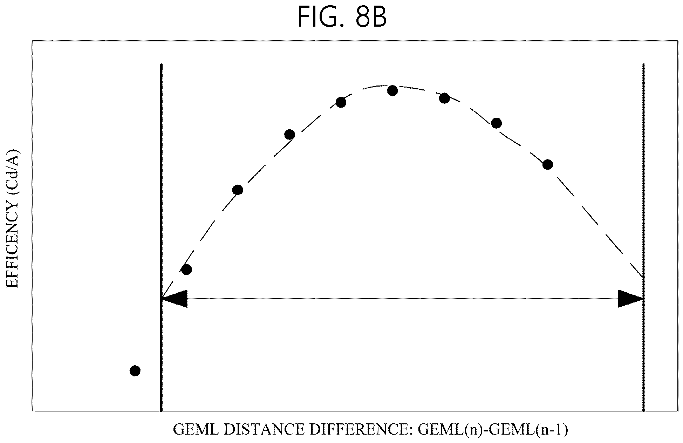

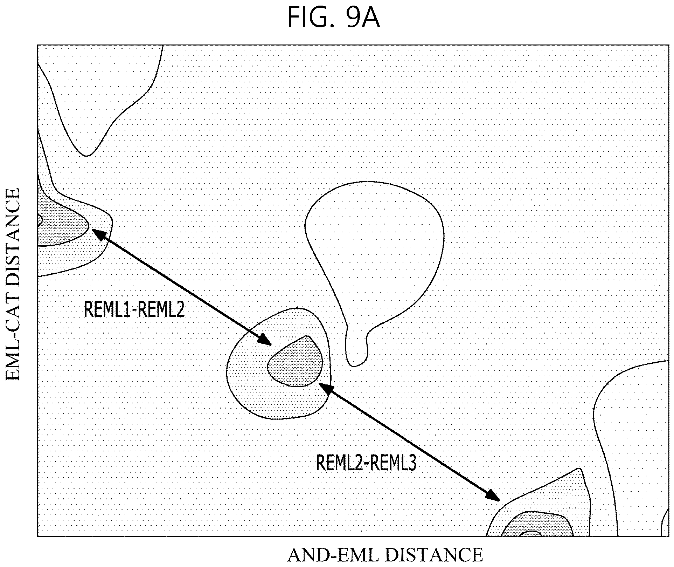

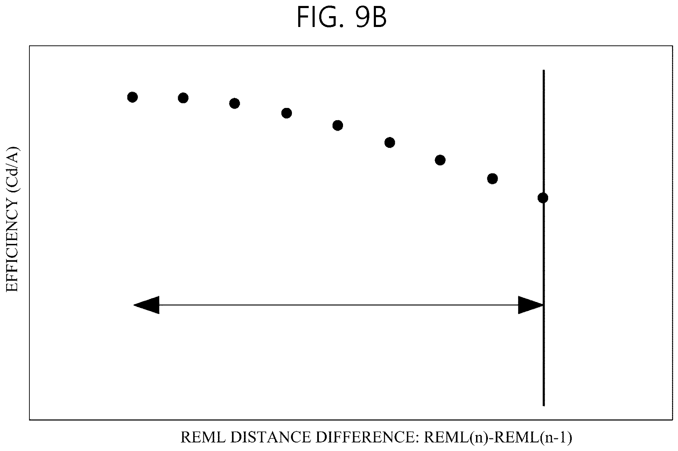

FIG. 7A is a contour map showing distances between the blue light emitting layers and the first electrode and distances between the blue light emitting layers and the second electrode in the blue light emitting device of FIG. 6. FIG. 7B is a graph showing efficiency according to a distance from the second electrode depending on the thickness of a hole transporting common layer in the mth light emitting stack of the blue light emitting device of FIG. 7A. FIG. 8A is a contour map showing distances between the green light emitting layers and the first electrode and distances between the green light emitting layers and the second electrode in the green light emitting device of FIG. 6. FIG. 8B is a graph showing efficiency according to a distance from the second electrode depending on the thickness of a hole transporting common layer in the mth light emitting stack of the green light emitting device of FIG. 8A. FIG. 9A is a contour map showing distances between the red light emitting layers and the first electrode and distances between the red light emitting layers and the second electrode in the red light emitting device of FIG. 6. FIG. 9B is a graph showing efficiency according to a distance from the second electrode depending on the thickness of a hole transporting common layer in the mth light emitting stack of the red light emitting device of FIG. 9A.

In the following test, the distance between the first electrode 120c and the second electrode 200 in the blue light emitting device was set to 2500±200 Å, the distance between the first electrode 120b and the second electrode 200 in the green light emitting device was set to 2800±200 Å, and the distance between the first electrode 120a and the second electrode 200 in the red light emitting device was set to 3200±200 Å. But embodiments of the present application are not limited thereto. The distance between the first electrode 120a and the second electrode 200 in the blue light emitting device, the green light emitting device and the red light emitting device may be variously changed.

In Table 4, each of distances between adjacent light emitting layers (a distance between the light emitting layers EML1 and EML2 and a distance between the light emitting layers EMI,2 and EML3) can be the total thickness of the hole injection and transport functional layers (i.e., the common layers), and specifically, can be the total thickness including the thicknesses of the hole transport layer 181 or 191, the p-type charge generation layer 152 or 154, and the hole transport auxiliary layers 183 or 184, or 193 or 194. The electron transport layer and the n-type charge generation layer can be excluded from each of the distances between adjacent light emitting layers (the distance between the light emitting layers EML1 and EML2 and the distance between the light emitting layers EMI,2 and EML3) in Table 4.

[Table 4]

| Category | Blue light emitting device | Green light emitting device | Red light emitting device |
|---|---|---|---|
| H (AND-CAT) | 2500±200 Å | 2800±200 Å | 3200±200 Å |
| Distance between EML1-EML2 | 50~200 Å | 30~200 Å | ~≤180 Å |
| Distance between EML2-EML3 | 80~230 Å | 50~240 Å | ~≤200 Å |

As set forth in Table 4 and shown in FIGs. 7A to 9B, the distance between adjacent light emitting layers of the green light emitting device having efficiency of a certain level or more is distributed over a relatively wider range than that of the blue light emitting device or the red light emitting device. Further, the red light emitting device has higher efficiency as the distance between adjacent light emitting layers decreases, and shows excellent efficiency in the range where the green light emitting device and the blue light emitting device have efficiency of the designated level or more, and this means that the red light emitting device has no efficiency loss even if the same configuration of the hole injection and transporting common layers as those of other color light emitting devices is disposed between adjacent light emitting layers. The blue light emitting device has a narrow range of a distance between adjacent light emitting layers having efficiency of the certain level or more, and has a shorter distance between the first electrode AND and the second electrode CAT than those of other color light emitting devices, and can be highly sensitive to changes in the thickness of the hole injection and transporting common layers between the adjacent light emitting layers. Therefore, the distances between adjacent light emitting layers of the blue light emitting device can be determined first, and then, the distances between adjacent light emitting layers of the green light emitting device and the red light emitting device can be determined. These distances between adjacent light emitting layers can be determined by the thicknesses of the hole transport layers 181 and 191 and the p-type charge generation layers 152 and 154 and/or application of the hole transport auxiliary layers 183 and 184, and 193 and 194 and a thickness difference therebetween.

The light emitting device of each subpixel of the light emitting display device according to the present disclosure can include the first to $m^{th}$ (m being a natural number of 3 or more) light emitting stacks provided between the first electrode 120a, 120b, or 120c and the second electrode 200, each light emitting stack including a light emitting layer emitting light of the same color, and the first to $(m-1)^{th}$ charge generation layers provided between adjacent light emitting stacks among the first to $m^{th}$ light emitting stacks, and all the light emitting layers provided in the first to $m^{th}$ light emitting stacks can be located in the resonance distance of the $(m-1)^{th}$ or less order. For optimal efficiency of each light emitting device, the distances between the first and second electrodes of the red light emitting device, the green light emitting device, and the blue light emitting device, which emit light of different colors, can be different. In addition, in the same light emitting device, efficiency can be improved by varying thicknesses of the hole injection and transporting common layers as the common provided between adjacent light emitting layers, for example, the hole transport layers, the p-type charge generation layers and the hole transport auxiliary layers. Alternatively, in the same light emitting device, efficiency can be improved by varying the thicknesses of the light emitting layers, which overlap each other, or varying the p-type dopant contents in the hole injection layers and the p-type charge generation layers.

Hereinafter, the connection relationship between the light emitting device and a thin film transistor of a substrate will be described.

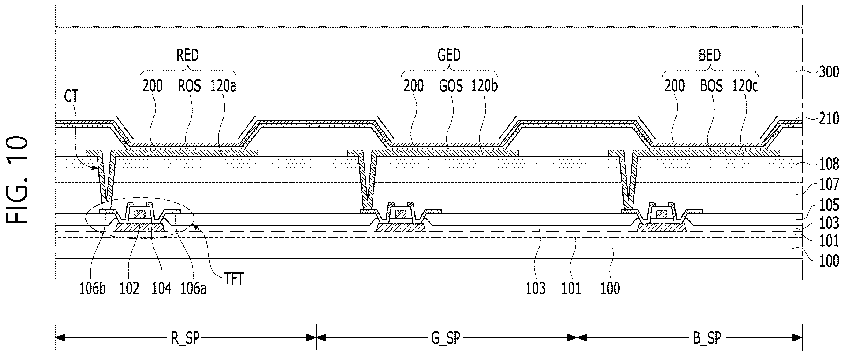

FIG. 10 is a cross-sectional view showing the light emitting display device according to one embodiment of the present disclosure.

As shown in FIG. 10, the light emitting display device according to one embodiment of the present disclosure can include a substrate 100 having a plurality subpixels R_SP, G_SP, and B-SP, light emitting devices RED, GED, and BED respectively provided in the subpixels R_SP, G_SP, and B-SP of the substrate 100, and a thin film transistor TFT provided in each of the subpixels R_SP, G_SP, and B-SP and connected to the first electrode 120a, 120b, or 120c of each of the subpixels R_SP, G_SP, and B-SP.

The thin film transistor TFT includes, for example, a gate electrode 102, a semiconductor layer 104, and a source electrode 106a and a drain electrode 106b connected to both sides of the semiconductor layer 104. In addition, a channel protective layer can be further provided on an area in which a channel of the semiconductor layer 104 is located to prevent direct connection between the source and drain electrodes 106a and 106b and the semiconductor layer 104. A buffer layer 101 can be located on the substrate 100, and the thin film transistor TFT can be located on the buffer layer 101. As an example, the channel protective layer and/or the buffer layer 101 may be omitted depending on the design.

A gate insulating film 103 is provided between the gate electrode 102 and the semiconductor layer 104.

The semiconductor layer 104 can be formed of, for example, any one of an oxide semiconductor, amorphous silicon, and a polycrystalline semiconductor, or a combination of two or more thereof. For example, if the semiconductor layer 104 is formed of an oxide semiconductor, a heating temperature required to form the thin film transistor can be lowered, freedom in use of the substrate 10 can be increased, and thus, the light emitting display device can be advantageous for application to a flexible display device.

A gate electrode 102 can be provided on the gate insulating film 103, and an interlayer insulating film 105 can be further provided between the gate electrode 102 and the source and drain electrodes 106a and 106b.

In addition, the drain electrode 106b of the thin film transistor TFT can be connected to the first electrode 120a, 120b, or 120c within a contact hole CT provided in first and second protective films 107 and 108.

The first protective film 107 is provided to primarily protect the thin film transistor TFT.

The second protective film 108 can be provided on the first protective film 107. The second protective film 108 can be omitted.

The first electrodes 120a, 120b, and 120c are formed on the second protective film 108. Each of the first electrode 120a, 120b, and 120c us formed on the surface of the second protective film 108 excluding the contact hole CT, and is connected to any one of the drain electrode 106b and the source electrode 106a to receive an electrical signal from the thin film transistor TFT.

Here, the substrate 100, the thin film transistors TFT, and the first and second protective films 107 and 108 can be collectively referred to as a thin film transistor array substrate 1000.

The light emitting devices RED, GED, and BED are formed on the thin film transistor array substrate 1000 including a bank 119 defining emission areas. Each light emitting device RED, GED, or BED includes the first electrode 120a, 120b, or 120c which is reflective, the second electrode 200 which is transflective and is provided to face the first electrode 120a, 120b, or 120c, and m (m being a natural number of 3 or more) or more light emitting stacks which are provided between the first electrode 120a, 120b, or 120c and the second electrode 200 and included within the vertical distance H described above with reference to FIG 6. In addition, each light emitting device RED, GED, or BED includes the light emitting layers emitting light of the same color in the three light emitting stacks within the vertical distance H, and the light emitting layers provided in the first to $m^{th}$ light emitting stacks are all located in the resonance distance of the $(m-1)^{th}$ or less order.

The thicknesses of the intermediate layer ROS included between the first electrode 120a and the second electrode 200 of the red light emitting device RED, the intermediate layer GOS between the first electrode 120b and the second electrode 200 of the green light emitting device GED, and the intermediate layer BOS between the first electrode 120c and the second electrode 200 of the blue light emitting device BED can be different.

The intermediate layers ROS, GOS, and BOS include in common, for example, the hole injection layer 131, the first hole transport layer 132, the first electron transport layer 133, the first n-type charge generation layer 151, the first p-type charge generation layer 152, the second hole transport layer 181, the second electron transport layer 185, the second n-type charge generation layer 153, the second p-type charge generation layer 154, the third hole transport layer 191, the third electron transport layer 195, the electron injection layer EIL, the second electrode 200, and the capping layer 210, which are provided in common not only in the first subpixel R_SP but also in the second subpixel G_SP and the third subpixel B_SP. The intermediate layer ROS of the red light emitting device RED can include red light emitting layers provided in the respective light emitting stacks to overlap each other, and can further include a red hole transport auxiliary layer selectively provided in some of the light emitting stacks. The intermediate layer GOS of the green light emitting device RED can include green light emitting layers provided in the respective light emitting stacks to overlap each other, and can further include a green hole transport auxiliary layer selectively provided in some of the light emitting stacks. The intermediate layer BOS of the blue light emitting device BED can include blue light emitting layers provided in the respective light emitting stacks to overlap each other, and can further include a blue hole transport auxiliary layer selectively provided in some of the light emitting stacks.

The first electrodes 120a, 120b, and 120c can be divided from each other depending on the respective subpixels, the remaining layers except for the first electrodes 120a, 120b, and 120c of the light emitting devices ED can be integrally provided throughout the entirety of an active area without distinction of the subpixels, or may be also divided from each other depending on the respective subpixels, without being limited thereto.

Either the first electrode 120a, 120b, or 120c or the second electrode 200 can be connected to the thin film transistor TFT.

The capping layer 210 can be further provided on the second electrode 200 to improve luminous efficiency and protect the respective light emitting devices RED, GED, and BED.

An encapsulation layer or an encapsulation substrate 300 can be further provided on the capping layer 210 to protect the light emitting devices RED, GED, and BED from external air and reduce or prevent moisture permeation.

Although the illustrated example is shown considering top emission, the embodiments of the present disclosure are not limited thereto.

A light emitting device and a light emitting display device according to one embodiment of the present disclosure include m (m being a natural number of 3 or more) or more light emitting stacks provided between first and electrodes, and sets a vertical distance between the first and second electrodes to a resonance distance of the $(m-1)^{th}$-order, thereby being capable of being driven at low power consumption while improving pure color efficiency through provision of the plural light emitting stacks.

The light emitting device and the light emitting display device according to one embodiment of the present disclosure can reduce the thicknesses of common layers related to hole injection and transport, and can provide thickness differences among the light emitting stacks to arrange light emitting layers in correspondence with the limited vertical distance between the first and second electrodes.

Further, the light emitting device and the light emitting display device according to one embodiment of the present disclosure can improve efficiency by adjusting the thicknesses of the light emitting layers, which overlap and emit light of the same color, or varying the contents of a p-type dopant included in the common layers related to hole injection and transport depending on each light emitting stack.

A light emitting device according to one aspect of the present disclosure comprises a first electrode and a second electrode facing each other, first to $m^{th}$ (m being a natural number of 3 or more) light emitting stacks between the first electrode and the second electrode, each light emitting stack comprising a light emitting layer to emit light of the same color and first to $(m-1)^{th}$ charge generation layers between adjacent light emitting stacks among the first to $m^{th}$ light emitting stacks. Each light emitting layer in the first to $m^{th}$ light emitting stacks can be located in a resonance distance of an $(m-1)^{th}$ or less order.

A light emitting display device according to a further aspect of the present disclosure comprises a substrate comprising a first subpixel, a second subpixel, and a third subpixel; a red light emitting device disposed at the first subpixel; a green light emitting device disposed at the second subpixel; and a blue light emitting device disposed at the third subpixel. Each of the red light emitting device, the green light emitting device, and the blue light emitting device comprises a first electrode and a second electrode to face each other. At least one of the red light emitting device, the green light emitting device, and the blue light emitting device comprises: first to $m^{th}$ light emitting stacks between the first electrode and the second electrode, where m is a natural number of 3 or more, each light emitting stack comprising a light emitting layer to emit light of a same color; and first to $(m-1)^{th}$ charge generation layers provided between adjacent light emitting stacks among the first to $m^{th}$ light emitting stacks. Light emitting layers in the first to $m^{th}$ light emitting stacks are located in a resonance distance of an $(m-1)^{th}$ or less order.

The light emitting device according to any one of these aspects may include one or more of the following features: Each of the firth to $m^{th}$ light emitting stacks may comprise a hole transporting common layer below the light emitting layer and/or an electron transporting common layer above the light emitting layer. Among hole transporting common layers of the firth to $m^{th}$ light emitting stacks, a hole transporting common layer having a maximum thickness may be not located in the first light emitting stack.

The first electrode and the first light emitting stack may be in contact with each other. The second electrode and a third light emitting stack may be in contact with each other. A second light emitting stack may be provided between the first light emitting stack and the third light emitting stack. A hole transporting common layer of the second light emitting stack may be thinner than each of a hole transporting common layer of the first light emitting stack and a hole transporting common layer of the third light emitting stack.

Each of a light emitting layer of the second light emitting stack and a light emitting layer of the third light emitting stack may be thicker than a light emitting layer of the first light emitting stack.

The hole transporting common layer of the second light emitting stack may have a thickness of 70 Å to 80 Å.

The first light emitting stack may comprise a hole injection layer in contact with the first electrode. The first charge generation layer between the first light emitting stack and the second light emitting stack may comprise a first n-type charge generation layer and a first p-type charge generation layer. A second charge generation layer between the second light emitting stack and the third light emitting stack may comprise a second n-type charge generation layer and a second p-type charge generation layer. Each of the hole injection layer, the first p-type charge generation layer, and the second p-type charge generation layer may comprise a p-type dopant.

A content of the p-type dopant may increase sequentially in an order of the hole injection layer, the first p-type charge generation layer, and the second p-type charge generation layer.

The light emitting display device may comprise a substrate comprising a first subpixel, a second subpixel, and a third subpixel, a red light emitting device at the first subpixel, a green light emitting device at the second subpixel and a blue light emitting device at the third subpixel.

Each of the red light emitting device, the green light emitting device, and the blue light emitting device may comprise a first electrode and a second electrode to face each other. At least one of the red light emitting device, the green light emitting device, and the blue light emitting device may comprise first to $m^{th}$ (m being a natural number of 3 or more) light emitting stacks between the first electrode and the second electrode, each light emitting stack comprising a light emitting layer to emit light of the same color, and first to $(m-1)^{th}$ charge generation layers provided between adjacent light emitting stacks among the first to $m^{th}$ light emitting stacks. Light emitting layers in the first to $m^{th}$ light emitting stacks may be located in a resonance distance of an $(m-1)^{th}$ or less order.

Vertical distances between the first electrodes and the second electrodes of the red light emitting device, the green light emitting device, and the blue light emitting device may be different.

Light emitting layers in the red light emitting device, the green light emitting device, and the blue light emitting device may be different, and/or may be spaced apart from each other in a plane.

Among hole transporting common layers of the firth to $m^{th}$ light emitting stacks, a hole transporting common layer having a maximum thickness may be not located in the first light emitting stack.

Each of the red light emitting device, the green light emitting device, and the blue light emitting device may comprise the first light emitting stack, the first charge generation layer, a second light emitting stack, a second charge generation layer, and a third light emitting stack sequentially provided on the first electrode. Each of the first light emitting stack, the second light emitting stack, and the third light emitting stack may comprise a hole transporting common layer below the light emitting layer and/or an electron transporting common layer above the light emitting layer. Each of the red light emitting device and the green light emitting device may further comprise a hole transport auxiliary layer in contact with the hole transporting common layer in at least one of the second light emitting stack and the third light emitting stack.

The hole transport auxiliary layer of the red light emitting device may have a different thickness from a thickness of the hole transport auxiliary layer of the green light emitting device.

The hole transporting common layer of the second light emitting stack may be thinner than each of the hole transporting common layer of the first light emitting stack and the hole transporting common layer of the third light emitting stack.

Each of the light emitting layer of the second light emitting stack and the light emitting layer of the third light emitting stack may be thicker than the light emitting layer of the first light emitting stack.

The first light emitting stack may comprise a hole injection layer in contact with the first electrode. The first charge generation layer between the first light emitting stack and the second light emitting stack may comprise a first n-type charge generation layer and a first p-type charge generation layer. A second charge generation layer between the second light emitting stack and the third light emitting stack may comprise a second n-type charge generation layer and a second p-type charge generation layer. Each of the hole injection layer, the first p-type charge generation layer, and the second p-type charge generation layer may comprise a p-type dopant.

A content of the p-type dopant may increase sequentially in order of the hole injection layer, the first p-type charge generation layer, and the second p-type charge generation layer.

As is apparent from the above description, a light emitting device and a light emitting display device according to one embodiment of the present disclosure have the following effects.

The light emitting device and the light emitting display device according to one embodiment of the present disclosure may include m (m being a natural number of 3 or more) or more light emitting stacks provided between first and electrodes, and/or may set a vertical distance between the first and second electrodes to a resonance distance of the $(m-1)^{th}$-order, thereby being capable of being driven at low power consumption while improving pure color efficiency through provision of the plural light emitting stacks.

The light emitting device and the light emitting display device according to one embodiment of the present disclosure can reduce the thicknesses of common layers related to hole injection and transport, and can provide thickness differences among the light emitting stacks to arrange light emitting layers in correspondence with the limited vertical distance between the first and second electrodes.

Further, the light emitting device and the light emitting display device according to one embodiment of the present disclosure can improve efficiency by adjusting the thicknesses of the light emitting layers, which overlap and emit light of the same color, or varying the contents of a p-type dopant included in the common layers related to hole injection and transport depending on each light emitting stack.

The light emitting device and the light emitting display device according to one embodiment of the present disclosure can be implemented without increase in a driving voltage using an intermediate layer having the same thickness as that of a second light emitting device having (m-1) light emitting stacks in which a vertical distance between first and second electrodes corresponds to an $(m-1)^{th}$ resonance order, and can thus be driven with low power consumption to achieve high efficiency with the same power consumption, thereby being capable of being continuously driven while minimizing increase in material costs, and thus being ecofriendly. Therefore, the light emitting device and the light emitting display device according to one embodiment of the present disclosure can exhibit environmental, social, and governance (ESG) effects.

It will be apparent to those skilled in the art that various modifications and variations can be made in the present disclosure without departing from the scope of the disclosure. Thus, it is intended that the present disclosure cover the modifications and variations of the present disclosure provided they come within the scope of the appended claims and their equivalents.

**Claims**

1. A light emitting device comprising:

   a first electrode and a second electrode facing each other;
   first to $m^{th}$ light emitting stacks between the first electrode and the second electrode, each light emitting stack comprising a light emitting layer to emit light of a same color, where m is a natural number of 3 or more; and
   first to $(m-1)^{th}$ charge generation layers between adjacent light emitting stacks among the first to $m^{th}$ light emitting stacks,
   wherein each light emitting layer in the first to $m^{th}$ light emitting stacks is located in a resonance distance of an $(m-1)^{th}$ or less order.

2. The light emitting device according to claim 1, wherein each of the firth to $m^{th}$ light emitting stacks comprises a hole transporting common layer disposed below the light emitting layer, and
   wherein, among hole transporting common layers of the firth to $m^{th}$ light emitting stacks, a hole transporting common layer having a maximum thickness is not located in the first light emitting stack.

3. The light emitting device according to any one of the preceding claims, wherein:

   the first electrode and the first light emitting stack are in contact with each other;
   the second electrode and a third light emitting stack are in contact with each other; and
   a second light emitting stack is provided between the first light emitting stack and the third light emitting stack.

4. The light emitting device according to any one of the preceding claims, wherein a hole transporting common layer of the second light emitting stack is thinner than each of a hole transporting common layer of the first light emitting stack and a hole transporting common layer of the third light emitting stack.

5. The light emitting device according to any one of the preceding claims, wherein each of a light emitting layer of the second light emitting stack and a light emitting layer of the third light emitting stack is thicker than a light emitting layer of the first light emitting stack.

6. The light emitting device according to any one of the preceding claims, wherein the hole transporting common layer of the second light emitting stack has a thickness of about 70 Å to about 80 Å.

7. The light emitting device according to any one of the preceding claims, wherein:

the first light emitting stack comprises a hole injection layer in contact with the first electrode;
the first charge generation layer between the first light emitting stack and the second light emitting stack comprises a first n-type charge generation layer and a first p-type charge generation layer;
a second charge generation layer between the second light emitting stack and the third light emitting stack comprises a second n-type charge generation layer and a second p-type charge generation layer; and
each of the hole injection layer, the first p-type charge generation layer, and the second p-type charge generation layer comprises a p-type dopant.

8. The light emitting device according to claim 7, wherein a content of the p-type dopant increases sequentially in order of the hole injection layer, the first p-type charge generation layer, and the second p-type charge generation layer.

9. The light emitting display device any one of the preceding claims, comprising:

a substrate comprising a first subpixel, a second subpixel, and a third subpixel;
a red light emitting device disposed at the first subpixel;
a green light emitting device disposed at the second subpixel; and
a blue light emitting device disposed at the third subpixel,
wherein at least one of the red light emitting device, the green light emitting device, and the blue light emitting device comprises:

the first electrode and the second electrode facing each other,

the first to m$^{th}$ light emitting stacks between the first electrode and the second electrode, where m is a natural number of 3 or more, each light emitting stack comprising a light emitting layer to emit light of a same color; and
the first to (m-1)$^{th}$ charge generation layers provided between adjacent light emitting stacks among the first to m$^{th}$ light emitting stacks, and

wherein the light emitting layers in the first to m$^{th}$ light emitting stacks are located in a resonance distance of an (m-1)$^{th}$ or less order.

10. The light emitting display device according to claim 9, wherein vertical distances between the first electrodes and the second electrodes of the red light emitting device, the green light emitting device, and the blue light emitting device are different from each other.

11. The light emitting display device according to claim 9 or 10, wherein light emitting layers in the red light emitting device, the green light emitting device, and the blue light emitting device are different and/or spaced apart from each other in a plane.

12. The light emitting display device according to claim 9, 10 or 11, wherein:

each of the red light emitting device, the green light emitting device, and the blue light emitting device comprises the first light emitting stack, the first charge generation layer, a second light emitting stack, a second charge generation layer, and a third light emitting stack sequentially provided on the first electrode;
each of the first light emitting stack, the second light emitting stack, and the third light emitting stack comprises a hole transporting common layer disposed below the light emitting layer and each of the red light emitting device and the green light emitting device further comprises a hole transport auxiliary layer in contact with the hole transporting common layer in at least one of the second light emitting stack and the third light emitting stack.

13. The light emitting display device according to claim 12, wherein the hole transport auxiliary layer of the red light emitting device has a thickness different from a thickness of the hole transport auxiliary layer of the green light emitting device.

14. The light emitting display device according to claim 12 or 13, wherein the hole transporting common layer of the second light emitting stack is thinner than each of the hole transporting common layer of the first light emitting stack and the hole transporting common layer of the third light emitting stack.

EP 4 593 565 A1

# FIG. 1

ED1

| | |
|---|---|
| CAT | ~200 |
| EIL | IH1_3 |
| ETL3 | |
| EML3 | |
| HTL3 | IH1_2 |
| pCGL2 | |
| nCGL2 | |
| ETL2 | |
| EML2 | |
| HTL2 | IH1_1 |
| pCGL1 | |
| nCGL1 | |
| ETL1 | |
| EML1 | |
| HTL1 | |
| HIL | |
| AND | ~110 |

S3, CGL2, S2, CGL1, S1

H

H1_1  H1_2  H1_3

# FIG. 2

FIG. 3

# FIG. 4

# FIG. 5A

# FIG. 5B

# FIG. 5C

# FIG. 6

RED

GED

BED

173

172
193
194

185

163

162
184
183

143

142

120a

210
200
195
171
191
154 } CGL2
153
185
161
181
152 } CGL1
151
133
141
132
131
120c

R_SP

G_SP

B_SP

120b

## FIG. 7A

EML-CAT DISTANCE

BEML1-BEML2

BEML2-BEML3

AND-EML DISTANCE

## FIG. 7B

BEML DISTANCE DIFFERENCE: BEML(n)-BEML(N-1)

## FIG. 8A

## FIG. 8B

EFFICENCY (Cd/A)

GEML DISTANCE DIFFERENCE: GEML(n)-GEML(n-1)

FIG. 9A

FIG. 9B

REML DISTANCE DIFFERENCE: REML(n)-REML(n-1)

## FIG. 10

Europäisches
Patentamt

European
Patent Office

Office européen
des brevets

# EUROPEAN SEARCH REPORT

**Application Number**

EP 24 22 3828

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/242419 A1 (NAKAMURA MASATO [JP] ET AL) 5 August 2021 (2021-08-05) | 1-3,7 | INV.<br>H10K50/15 |
| A | * paragraphs [0001], [0019], [0084] - [0086], [0105], [0107], [0110], [0197] - [0199], [0221] - [0224], [0272] - [0275]; figures 1-3; table 2 * | 4-6,8-14 | H10K50/19<br>H10K50/852<br>H10K59/80 |
| X | KR 2022 0124548 A (SAMSUNG ELECTRONICS CO LTD [KR]) 14 September 2022 (2022-09-14) | 1,3,5,6,9-13 | |
| A | * paragraphs [0001], [0024], [0040], [0054], [0058], [0060], [0064] - [0065], [0067] - [0069], [0081] - [0084]; figures 10,17 * | 2,4,7,8,14 | |
| X | CN 113 555 509 B (BOE TECHNOLOGY GROUP CO LTD) 15 August 2023 (2023-08-15) | 1,3,4,9,12,14 | |
| A | * paragraphs [0001], [0026], [0030], [0033], [0039] - [0041], [0043]; figure 1 * | 2,5-8,10,11,13 | |

**TECHNICAL FIELDS SEARCHED (IPC)**

H10K

The present search report has been drawn up for all claims

| Place of search | Date of completion of the search | Examiner |
|---|---|---|
| The Hague | 6 May 2025 | Baum, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 3828

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2025

| Patent document cited in search report | Publication date | Patent family member(s) | | Publication date |
|---|---|---|---|---|
| US 2021242419 A1 | 05-08-2021 | CN | 112243599 A | 19-01-2021 |
| | | JP | 2021182459 A | 25-11-2021 |
| | | KR | 20210015958 A | 10-02-2021 |
| | | US | 2021242419 A1 | 05-08-2021 |
| | | WO | 2019235475 A1 | 12-12-2019 |
| KR 20220124548 A | 14-09-2022 | CN | 115020599 A | 06-09-2022 |
| | | EP | 4053929 A1 | 07-09-2022 |
| | | JP | 2022135948 A | 15-09-2022 |
| | | KR | 20220124548 A | 14-09-2022 |
| | | US | 2022285643 A1 | 08-09-2022 |
| CN 113555509 B | 15-08-2023 | NONE | | |

EPO FORM P0459

For more details about this annex : see Official Journal of the European Patent Office, No. 12/82

**REFERENCES CITED IN THE DESCRIPTION**

**Patent documents cited in the description**

• KR 1020240011781